# EUROPEAN PATENT APPLICATION

(11) **EP 4 803 323 A1**
(43) Date of publication of application: **09.09.2026**
(21) Application number: 24885537.1
(22) Date of filing: 22.10.2024
(51) Int. Cl.: B41N 1/14, B41C 1/10, B41M 1/06, G03F 7/00, G03F 7/11

(54) **ON-PRESS-DEVELOPMENT-TYPE PLANOGRAPHIC PRINTING PLATE PRECURSOR, METHOD FOR FABRICATING PLANOGRAPHIC PRINTING PLATE, AND PLANOGRAPHIC PRINTING METHOD**

(30) Priority: 31.10.2023 JP 2023187017
(71) Applicant: FUJIFILM Corporation, Tokyo 106-8620 (JP)
(72) Inventor: MIYAGAWA, Yuya, Haibara-gun, Shizuoka 421-0396 (JP); HIRANO, Natsumi, Haibara-gun, Shizuoka 421-0396 (JP); OTA, Keisuke, Haibara-gun, Shizuoka 421-0396 (JP); WATANABE, Shumpei, Haibara-gun, Shizuoka 421-0396 (JP)
(74) Representative: HGF
(86) International application number: PCT/JP2024/037610
(87) International publication number: WO 2025/094764

(57) **Abstract**

Provided are an on-press development type lithographic printing plate precursor comprising: a support; and an image recording layer on the support, wherein the image recording layer contains a polymerizable compound and polymer particles, a median diameter of the polymer particles is in a range of 50 nm to 120 nm, a content of the polymer particles is 42% by mass or more and 90% by mass or less with respect to a total mass of the image recording layer, and a standard deviation of an area ratio of a non-stained portion in a cross-sectional image is less than 6, the cross-sectional image being obtained by performing an osmium staining treatment on a cross section of the lithographic printing plate precursor in a thickness direction, performing observation the cross section with a scanning electron microscope, and binarizing the cross-sectional image into a stained portion and the non-stained portion.

## Description

### BACKGROUND OF THE INVENTION

### 1. Field of the Invention

The present disclosure relates to an on-press development type lithographic printing plate precursor, a method of preparing a lithographic printing plate, and a lithographic printing method.

### 2. Description of the Related Art

In general, a lithographic printing plate is composed of lipophilic image areas that receive ink during a printing process and hydrophilic non-image areas that receive a dampening water. Lithographic printing is a printing method that utilizes the property that water and oil-based ink repel each other to cause differences in ink attachment behavior on a surface of the lithographic printing plate by using lipophilic image areas on the lithographic printing plate as an ink-receiving area and using hydrophilic non-image areas on the lithographic printing plate as dampening water-receiving areas (non-ink-receiving areas), thereby depositing the ink only to the image areas, and then transferring the ink to a printing material, such as paper.

In the related art, in order to prepare this lithographic printing plate, a lithographic printing plate precursor (PS plate) has been widely used which is obtained by providing a lipophilic photosensitive resin layer (image recording layer) on a hydrophilic support. Generally, a lithographic printing plate is obtained by a plate making method of exposing a lithographic printing plate precursor through an original picture such as a lith film, then keeping a portion of an image recording layer that will be an image area while removing other unnecessary portions of the image recording layer by dissolving such portions in an alkaline developer or an organic solvent, and forming a non-image area by exposing the hydrophilic surface of a support.

In response to the intensifying interest in the global environment, an environmental issue of waste liquid generated by wet treatments such as a development treatment has gathered more attention.

Regarding the environmental issue described above, an attempt is made to simplify development or plate making or to remove treatments. As one of simple preparation methods, a method called "on-press development" is being carried out. That is, on-press development is a method of exposing a lithographic printing plate precursor, then immediately mounting the precursor on a printer without performing development of the related art, and removing an unnecessary portion of the image recording layer at an early stage of the ordinary printing step.

In the present disclosure, a lithographic printing plate precursor that can be used for such on-press development is called "on-press development type lithographic printing plate precursor"

Examples of the lithographic printing plate precursors in the related art include those described in JP2019-64269A or JP2016-155271A.

WO2020/262694A discloses a lithographic printing plate precursor including an aluminum support and an image recording layer formed on the aluminum support, in which the image recording layer contains resin particles A having an ethylenically unsaturated group and a compound B having an ethylenically unsaturated group other than the resin particles A, and an ethylenically unsaturated bond value is 1.5 mmol/g or more.

WO2020/262695A discloses a particle for an on-press development type lithographic printing plate precursor, which is a particle containing a resin having a structural unit formed of an aromatic vinyl compound and a structural unit formed of an acrylonitrile compound, in which the particle is a particulated particle by a surfactant, and an image recording layer contains the particle for an on-press development type lithographic printing plate precursor.

### SUMMARY OF THE INVENTION

An object to be achieved by an embodiment of the present disclosure is to provide an on-press development type lithographic printing plate precursor having excellent printing durability and excellent developing residue suppressing property.

An object of another embodiment of the present disclosure is to provide a method of preparing a lithographic printing plate and a lithographic printing method in which the on-press development type lithographic printing plate precursor is used.

Means for solving the above-described problems include the following aspects.
<1> An on-press development type lithographic printing plate precursor comprising: a support; and an image recording layer on the support, wherein the image recording layer contains a polymerizable compound and polymer particles, a median diameter of the polymer particles is in a range of 50 nm to 120 nm, a content of the polymer particles is 42% by mass or more and 90% by mass or less with respect to a total mass of the image recording layer, and a standard deviation of an area ratio of a non-stained portion in a cross-sectional image is less than 6, the cross-sectional image being obtained by performing an osmium staining treatment on a cross section of the lithographic printing plate precursor in a thickness direction, performing observation the cross section with a scanning electron microscope, and binarizing the cross-sectional image into a stained portion and the non-stained portion.
<2> The on-press development type lithographic printing plate precursor according to <1>, in which the polymer particles are polymer particles having a structural unit formed from an acrylonitrile compound and a structural unit having a polyalkylene oxide structure.
<3> The on-press development type lithographic printing plate precursor according to <2>, in which the polymer particles are polymer particles having a structural unit formed of an aromatic vinyl compound, a structural unit formed of an acrylonitrile compound, and a structural unit having a polyalkylene oxide structure.
<4> The on-press development type lithographic printing plate precursor according to <2> or <3>, in which the polyalkylene oxide structure is a polyethylene oxide structure.
<5> The on-press development type lithographic printing plate precursor according to any one of <2> to <4>, in which the number of repeating units of the polyalkylene oxide structure is in a range of 3 to 10.
<6> The on-press development type lithographic printing plate precursor according to any one of <2> to <5>, in which a content of the structural unit having a polyalkylene oxide structure in the polymer particles is 10% by mass or more with respect to a total mass of a polymer.
<7> The on-press development type lithographic printing plate precursor according to any one of <1> to <6>, in which the content of the polymer particles is 45% by mass or more with respect to the total mass of the image recording layer.
<8> The on-press development type lithographic printing plate precursor according to <7>, in which the content of the polymer particles is 55% by mass or more with respect to the total mass of the image recording layer.
<9> The on-press development type lithographic printing plate precursor according to any one of <1> to <8>, in which the median diameter of the polymer particles is in a range of 50 nm to 100 nm.
<10> The on-press development type lithographic printing plate precursor according to <9>, in which the median diameter of the polymer particles is in a range of 50 nm to 90 nm.
<11> The on-press development type lithographic printing plate precursor according to any one of <1> to <10>, in which the polymerizable compound contains an oligomer.
<12> The on-press development type lithographic printing plate precursor according to any one of <1> to <11>, further comprising: an interlayer between the support and the image recording layer, in which the interlayer contains a copolymer having a support absorptive group and a hydrophilic group.
<13> The on-press development type lithographic printing plate precursor according to any one of <1> to <12>, further comprising: an overcoat layer on the image recording layer, the overcoat layer containing an inorganic lamellar compound.
<14> The on-press development type lithographic printing plate precursor according to any one of <1> to <13>, further comprising: an overcoat layer on the image recording layer, the overcoat layer containing a water-soluble polymer, in which a thickness of the overcoat layer is greater than a thickness of the image recording layer.
<15> The on-press development type lithographic printing plate precursor according to any one of <1> to <14>, further comprising: an oxide film on a surface of the support, in which the oxide film has micropores extending in a depth direction from a surface of the oxide film on a side of the image recording layer in the oxide film, and a large-diameter pore portion in which an average pore diameter of the micropores at the surface of the oxide film is in a range of15 nm or greater and 100 nm or less and a small-diameter pore portion having an average pore diameter of 15 nm or less, small-diameter pore portion communicating with a bottom portion of the large-diameter pore portion and further extending in the depth direction from a communicating position.
<16> The on-press development type lithographic printing plate precursor according to any one of <1> to <15>, further comprising: an oxide film on a surface of the support, in which the oxide film has micropores extending in a depth direction from a surface of the oxide film on a side of the image recording layer in the oxide film, and a maximum diameter inside the micropores is 1.2 to 10 times an average pore diameter of the surface of the oxide film with respect to an average pore diameter of the micropores at the surface of the oxide film.
<17> An on-press development type lithographic printing plate precursor comprising: a support; and an image recording layer on the support, in which the image recording layer contains a polymerizable compound and polymer particles, a median diameter of the polymer particles is 50 nm to 120 nm, a content of the polymer particles is 42% by mass or more and 90% by mass or less with respect to a total mass of the image recording layer, and the polymer particles are polymer particles having a structural unit formed of an acrylonitrile compound in an amount of 65% by mass or more and a structural unit having a polyalkylene oxide structure in an amount of 10% by mass or more with respect to a total mass of the polymer particles.
<18> A method of preparing a lithographic printing plate, comprising: a step of exposing the on-press development type lithographic printing plate precursor according to claim 1 or 17 in an imagewise manner; and a step of supplying at least one selected from the group consisting of a printing ink and dampening water on a printing press to remove an image recording layer in a non-image area.
<19> A lithographic printing method comprising: a step of exposing the on-press development type lithographic printing plate precursor according to claim 1 or 17 in an imagewise manner; a step of supplying at least one selected from the group consisting of a printing ink and dampening water on a printing press to remove an image recording layer in a non-image area and to prepare a lithographic printing plate; and a step of performing printing using the obtained lithographic printing plate.

According to an embodiment of the present disclosure, it is possible to provide an on-press development type lithographic printing plate precursor having excellent printing durability and excellent developing residue suppressing property.

According to another embodiment of the present disclosure, it is possible to provide a method of preparing a lithographic printing plate and a lithographic printing method in which the on-press development type lithographic printing plate precursor is used.

### BRIEF DESCRIPTION OF THE DRAWINGS

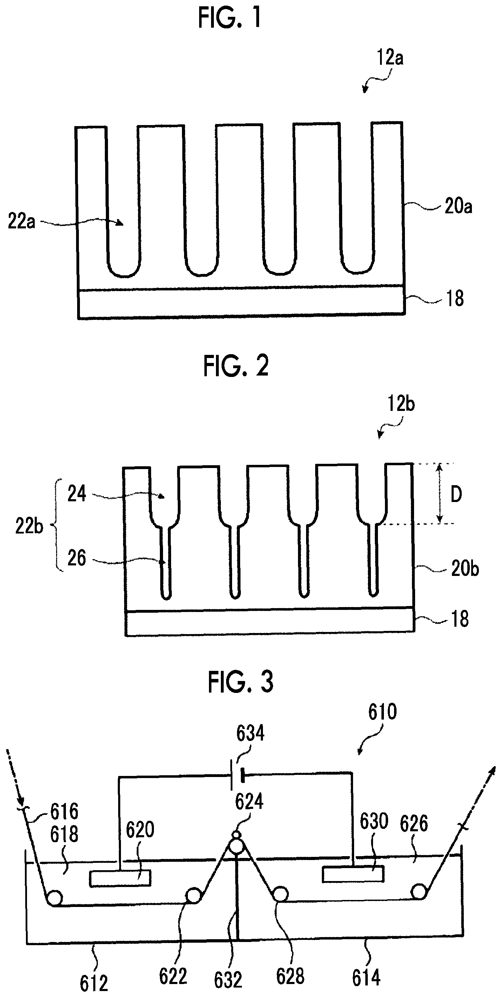

**[**0010] FIG. 1 is a schematic cross-sectional view of an embodiment of a support.
FIG. 2 is a schematic cross-sectional view of another embodiment of a support.
FIG. 3 is a schematic view of an anodization treatment device used for an anodization treatment in a manufacturing method of a support having an anodic oxide film.
FIG. 4 is a side view illustrating the concept of a brush graining step used in a mechanical roughening treatment in production of an aluminum support.
FIG. 5 is a graph showing an example of an alternating waveform current waveform diagram used for an electrochemical roughening treatment.
FIG. 6 is a side view illustrating an example of a radial type cell in the electrochemical roughening treatment using an alternating current.

### DESCRIPTION OF THE PREFERRED EMBODIMENTS

**[**0011] Hereinafter, the contents of the present disclosure will be described in more detail. The description of configuration requirements below is made based on representative embodiments of the present disclosure in some cases, but the present disclosure is not limited to such embodiments.

In the present disclosure, a numerical range expressed using "to" includes numerical values listed before and after "to" as the lower limit value and the upper limit value.

Regarding a term, group (atomic group) of this present disclosure, a term with no description of "substituted" and "unsubstituted" includes both a group not including a substituent and a group including a substituent. For example, "alkyl group" includes not only an alkyl group having no substituent (unsubstituted alkyl group) but also an alkyl group having a substituent (substituted alkyl group).

In the present disclosure, "(meth)acryl" is a term used to explain a concept including both the acryl and methacryl, and "(meth)acryloyl" is a term used to explain a concept including both the acryloyl and methacryloyl.

The term "step" in the present disclosure means not only an independent step but also a step that cannot be clearly differentiated from other steps as long as the intended goal of the step is achieved.

In the present disclosure, "% by mass" and "% by weight" have the same meaning, and "part(s) by mass" and "part(s) by weight" have the same meaning.

In the present disclosure, unless otherwise specified, as each component contained in a composition or each structural unit contained in a polymer, one component or one structural unit may be used alone, or two or more components or two or more structural units may be used in combination.

In the present disclosure, in a case where there is a plurality of substances corresponding to each component in a composition, or in a case where there is a plurality of structural units corresponding to each structural unit in a polymer, unless otherwise specified, the amount of each component in the composition or the amount of each structural unit in the polymer means the total amount of the plurality of corresponding substances present in the composition or the total amount of the plurality of corresponding structural units present in the polymer.

In the present disclosure, a combination of two or more preferred aspects is a more preferred aspect.

In the present disclosure, unless otherwise specified, each of the weight-average molecular weight (Mw) and number-average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

In the present disclosure, the term "lithographic printing plate precursor" refers not only to a lithographic printing plate precursor but also to a key plate precursor. The term "lithographic printing plate" refers not only to a lithographic printing plate prepared by performing operations such as exposure and development as necessary on a lithographic printing plate precursor but also to a key plate. In a case of the key plate precursor, operations of exposure and development are not necessarily required. In addition, a key plate is a planographic printing plate precursor for attachment to a plate cylinder which is not used, for example, in a case where printing is performed on a part of a paper surface with one or two colors in color newspaper printing.

In the present disclosure, "*" in a chemical structural formula represents a bonding position with other structures.

### <On-press development type lithographic printing plate precursor>

A first embodiment of an on-press development type lithographic printing plate precursor (also simply referred to as "lithographic printing plate precursor") according to the present disclosure includes a support; and an image recording layer on the support, in which the image recording layer contains a polymerizable compound and polymer particles, a median diameter of the polymer particles is 50 nm to 120 nm, a content of the polymer particles is 42% by mass or more and 90% by mass or less with respect to a total mass of the image recording layer, and a standard deviation of a non-stained portion area ratio of a cross-sectional image obtained by performing an osmium staining treatment on a cross section of the lithographic printing plate precursor in a thickness direction and observing the cross section with a scanning electron microscope, the cross-sectional image being subjected to binarization treatment on a stained portion and a non-stained portion, is less than 6.

A second embodiment of the on-press development type lithographic printing plate precursor according to the present disclosure includes a support; and an image recording layer on the support, in which the image recording layer contains a polymerizable compound and polymer particles, a median diameter of the polymer particles is 50 nm to 120 nm, a content of the polymer particles is 42% by mass or more and 90% by mass or less with respect to a total mass of the image recording layer, and the polymer particles are polymer particles having 65% by mass or more of a structural unit formed of an acrylonitrile compound and 10% by mass or more of a structural unit having a polyalkylene oxide structure with respect to a total mass of the polymer particles.

In a case where a term such as "on-press development type lithographic printing plate precursor according to the present disclosure" or "lithographic printing plate precursor according to the present disclosure" is simply mentioned in the present specification, unless otherwise specified, the term refers to both the first embodiment and the second embodiment. Furthermore, in a case where a term such as "image recording layer" is simply mentioned, unless otherwise specified, the term refers to the image recording layer of both the first embodiment and the second embodiment, or the like.

In the on-press development type lithographic printing plate precursor in the related art, in a case where the image recording layer contains polymer particles having a small particle diameter and a median diameter of 50 nm to 120 nm, the polymer particles having a small particle diameter are likely to aggregate, and the image recording layer in which a large number of aggregates of the polymer particles are observed is obtained. Further, from the viewpoint of improving printing durability, even in a case where a large amount of polymer particles are contained in the image recording layer, a large amount of the aggregates are generated in the same manner, the aggregates are likely to be deposited as developing residues, and the strength of the image recording layer is reduced in a portion where the aggregates are generated, so that the printing durability and the developing residue suppressing property are not sufficient.

In the first embodiment of the lithographic printing plate precursor according to the present disclosure, the image recording layer contains a polymerizable compound and polymer particles, a median diameter of the polymer particles is 50 nm to 120 nm, a content of the polymer particles is 42% by mass or more and 90% by mass or less with respect to a total mass of the image recording layer, and a standard deviation of the non-stained portion of a cross-sectional image obtained by performing an osmium staining treatment on a cross section of the lithographic printing plate precursor in a thickness direction and observing the cross section with a scanning electron microscope, the cross-sectional image being subjected to binarization treatment on a stained portion and a non-stained portion, is less than 6. Therefore, it is presumed that it is possible to provide an on-press development type lithographic printing plate precursor having excellent printing durability and excellent developing residue suppressing property, in which even in a case of an image recording layer containing a large amount of polymer particles having a small particle diameter, the image recording layer has high dispersibility of the polymer particles in which aggregation of the polymer particles is suppressed and high uniformity.

In addition, in the second embodiment of the lithographic printing plate precursor according to the present disclosure, the image recording layer contains a polymerizable compound and polymer particles, a median diameter of the polymer particles is 50 nm to 120 nm, a content of the polymer particles is 42% by mass or more and 90% by mass or less with respect to a total mass of the image recording layer, and the polymer particles are polymer particles having 65% by mass or more of a structural unit formed of an acrylonitrile compound and 10% by mass or more of a structural unit having a polyalkylene oxide structure with respect to a total mass of the polymer particles. Therefore, it is presumed that it is possible to provide an on-press development type lithographic printing plate precursor having excellent printing durability and excellent developing residue suppressing property, in which even in a case of an image recording layer containing a large amount of polymer particles having a small particle diameter, the image recording layer has high dispersibility of the polymer particles in which aggregation of the polymer particles is suppressed and high uniformity.

Hereinafter, each of the configuration requirements in the lithographic printing plate precursor according to the present disclosure will be specifically described.

### (Standard deviation of non-stained portion)

In the first embodiment of the on-press development type lithographic printing plate precursor according to the present disclosure, a standard deviation of a non-stained portion area ratio of a cross-sectional image obtained by performing an osmium staining treatment on a cross section of the lithographic printing plate precursor in a thickness direction and observing the cross section with a scanning electron microscope, the cross-sectional image being subjected to binarization treatment on a stained portion and a non-stained portion, is less than 6, and from the viewpoint of printing durability and developing residue suppressing property, the standard deviation is preferably less than 5.1 and more preferably less than 4.2. As the standard deviation is smaller, it means that the non-polymerizable portion is more uniformly present in the film, and the printing durability is more excellent and the developing residue suppressing property is more excellent.

In addition, in the second embodiment of the on-press development type lithographic printing plate precursor according to the present disclosure, a standard deviation of a non-stained portion area ratio of a cross-sectional image obtained by performing an osmium staining treatment on a cross section of the lithographic printing plate precursor in a thickness direction and observing the cross section with a scanning electron microscope, the cross-sectional image being subjected to binarization treatment on a stained portion and a non-stained portion, is preferably less than 6, more preferably less than 5.1, and particularly preferably less than 4.2, from the viewpoint of printing durability and developing residue suppressing property.

As a specific method for obtaining a lithographic printing plate precursor having a small standard deviation, it is effective to increase the dispersibility of the polymer particles contained in the image recording layer. As the particles having good dispersibility, polymer particles having a pendant group including a hydrophilic poly(alkylene oxide) segment are preferable, which will be described in detail later.

A method of measuring the standard deviation of the non-stained portion in the present disclosure is as follows.

### -Osmium staining method-

The lithographic printing plate precursor is cut out to have a size of about 10 mm square, and subjected to gas-phase dyeing using a 2% by mass aqueous osmium acid solution. The dyeing is performed at about 22°C for 24 hours.

### -Scanning electron microscope (SEM) observation method-

After cross-sectioning with an argon (Ar) ion beam after osmium dyeing, a conductive treatment is performed with a carbon coating, and reflection electron observation is performed with a semi-inlens type SEM manufactured by Hitachi High-Tech Corporation at an acceleration voltage of 5 kV. The imaging magnification is 50,000 times, and 10 visual fields are imaged (N = 10).

As image processing of binarizing the obtained cross-sectional SEM image into a stained portion and a non-stained portion, imageJ (Fiji) which is image processing software is used. From the obtained cross-sectional SEM image, the image recording layer is selected, noise is filtered with a Median filter (2 pixels), and then binarization processing (Threshold) is performed. The threshold value of Threshold is determined by Auto (Li). The obtained binarized image is subjected to noise filtering with a Median filter (2 pixels), and then the area ratio of the non-stained portion is measured. The standard deviation of the area ratio of the non-stained portion is calculated from the visual field data of N = 10.

The osmium dyeing is a method in which osmium is bonded to an ethylenically unsaturated bond contained in a polymerizable compound, and the reflection electron of a portion dyed with osmium having a large atomic number is increased and can be clearly observed. The dyed portion (polymerizable compound) appears white in the cross-sectional image obtained by SEM, and the non-stained portion (polymer particles or other non-polymerizable additives) appears black in the cross-sectional image obtained by SEM.

### (Image recording layer)

The image recording layer in the lithographic printing plate precursor according to the present disclosure is preferably a water-soluble or water-dispersible negative tone image recording layer.

In addition, in the image recording layer in the lithographic printing plate precursor according to the present disclosure, from the viewpoint of on-press developability, a non-exposed portion of the image recording layer is preferably removable by at least any of dampening water or printing ink.

Hereinafter, each of the components to be incorporated into the image recording layer will be specifically described.

### [Polymer particles]

The image recording layer contains polymer particles. The polymer particles contribute to the improvement of printing durability and on-press developability.

The polymer particles are preferably polymer particles that can convert the image recording layer into hydrophobic when heat is applied thereto. The polymer particles are preferably at least one selected from the group consisting of hydrophobic thermoplastic polymer particles and microcapsules encompassing a hydrophobic compound, and particularly preferably hydrophobic thermoplastic polymer particles.

Specific examples of polymers constituting the hydrophobic thermoplastic polymer particles include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylates or methacrylates having polyalkylene structures, and mixtures of these.

Examples of the microcapsule include those obtained by encapsulating all or some of the constituent components of the image recording layer in a microcapsule as described in JP2001-277740A and JP2001-277742A. The constituent components of the image recording layer can also be contained in the exterior of the microcapsules. In a preferred aspect of the image recording layer containing microcapsules, hydrophobic constituent components are encapsulated in the microcapsules and hydrophilic constituent components are incorporated into the exterior of the microcapsules.

The median diameter of the polymer particles is 50 nm to 120 nm, and from the viewpoint of printing durability and developing residue suppressing property, it is preferably 50 nm to 100 nm and more preferably 50 nm to 90 nm. As the particle diameter of the polymer is smaller, the printing durability is more excellent.

The median diameter of the polymer particles in the present disclosure is obtained by measuring the particle diameter by a dynamic light scattering method. In a case where the polymer particles are isolated from the plate and the particle diameter is measured, the obtained polymer particles are redispersed in a solvent by the following method, and then the particle diameter is measured.

### -Method of isolating polymer particles from plate-

A plate on which the image recording layer is coated is immersed in a mixed solvent A of 2-butanone/1-methoxy-2-propanol/methanol/pure water = 40/30/20/10, and the plate is irradiated with ultrasonic waves for 10 seconds to prepare a dispersion liquid of the image recording layer. Then, the dispersion liquid is centrifugally separated under the conditions of 5,000 rpm for 10 minutes to obtain a precipitate B in a bottom portion of a container. After discarding the supernatant solution, the mixed solvent A is added again to redisperse the precipitate, and then the precipitate is centrifugally separated under the conditions of 5,000 rpm for 10 minutes to obtain a precipitate C in the bottom portion of the container. After discarding the supernatant solution, the precipitate C is vacuum-dried (50°C, 16 hours) to obtain a powder of polymer particles.

In addition, as the method of measuring the median diameter of the polymer particles, a method of calculating the median diameter from an image obtained by a semi-inlens type SEM may be used. The specific measuring method is a method shown below.

The obtained powder of polymer particles is scattered and fixed on a carbon tape, and then subjected to a conductive treatment, and observed with a semi-inlens type SEM manufactured by Hitachi High-Tech Corporation at an acceleration voltage of 2 kV. The imaging is performed at an imaging magnification of 100,000 times. The number of imaging visual fields is N = 15 or more (the number of sheets in which the number of extracted particles is 400 or more, which will be described later). In the captured image, all polymer particles in which the particles do not overlap with each other and the contour can be determined are extracted as much as possible, and each particle diameter is measured. The median diameter is calculated from the obtained particle diameters (400 or more).

One kind of polymer particles may be used alone, or two or more kinds of polymer particles may be used in combination.

The content of the polymer particles in the lithographic printing plate precursor according to the present disclosure is 42% by mass or more and 90% by mass or less with respect to the total mass of the image recording layer, and from the viewpoint of printing durability and developing residue suppressing property, the content is preferably 45% by mass or more and more preferably 55% by mass or more.

In addition, from the viewpoint of printing durability and developing residue suppressing property, the content of the polymer particles in the lithographic printing plate precursor according to the present disclosure is preferably 45% by mass to 85% by mass and more preferably 55% by mass to 75% by mass with respect to the total mass of the image recording layer.

As a preferred aspect, the polymer particles have a hydrophobic main chain, and includes both
i) a constituent unit having a pendant cyano group directly bonded to the hydrophobic main chain, and
ii) a constituent unit having a pendant group that contains a hydrophilic poly(alkylene oxide) segment.

Preferred examples of the above-described hydrophobic main chain include an acrylic resin chain.

Preferred examples of the pendant-cyano group include -[CH₂CH(C°N)-] and - [CH₂C(CH₃)(C≡N)-].

In addition, the structural unit having the pendant cyano group can be easily derived from an ethylenically unsaturated monomer, for example, acrylonitrile or methacrylonitrile, or a combination of these.

Furthermore, as an alkylene oxide in the hydrophilic poly(alkylene oxide) segment, ethylene oxide or a propylene oxide is preferable, and ethylene oxide is more preferable.

The number of repeating units of the alkylene oxide structure in the hydrophilic poly(alkylene oxide) segment is preferably 2 to 100, more preferably 3 to 55, and particularly preferably 3 to 10.

As the resin particles having a hydrophobic main chain and including both i) constituent unit having the pendant cyano group directly bonded to the hydrophobic main chain and ii) constituent unit having a pendant group including the hydrophilic poly(alkylene oxide) segment, for example, the particles described in paragraphs "0039" to "0068" of JP2008-503365A are preferable.

In the second embodiment of the lithographic printing plate precursor according to the present disclosure, the polymer particles are polymer particles having 65% by mass or more of a structural unit formed of an acrylonitrile compound and 10% by mass or more of a structural unit having a polyalkylene oxide structure with respect to the total mass of the polymer particles, and from the viewpoint of printing durability and developing residue suppressing property, it is preferable that the polymer particles further have a structural unit formed of an aromatic vinyl compound.

In addition, from the viewpoint of printing durability and developing residue suppressing property, in the first embodiment of the lithographic printing plate precursor according to the present disclosure, the polymer particles are preferably polymer particles having a structural unit formed of an acrylonitrile compound and a structural unit having a polyalkylene oxide structure, and more preferably polymer particles having a structural unit formed of an aromatic vinyl compound, a structural unit formed of an acrylonitrile compound, and a structural unit having a polyalkylene oxide structure.

In the second embodiment of the lithographic printing plate precursor according to the present disclosure, the polymer particles are polymer particles having 65% by mass or more of a structural unit formed of an acrylonitrile compound and 10% by mass or more of a structural unit having a polyalkylene oxide structure with respect to the total mass of the polymer particles, and from the viewpoint of printing durability and developing residue suppressing property, it is preferable that the polymer particles further have a structural unit formed of an aromatic vinyl compound.

In addition, from the viewpoint of printing durability and developing residue suppressing property, in the first embodiment of the lithographic printing plate precursor according to the present disclosure, the polymer particles are preferably polymer particles having a structural unit formed of an acrylonitrile compound and a structural unit having a polyalkylene oxide structure, and more preferably polymer particles having a structural unit formed of an aromatic vinyl compound, a structural unit formed of an acrylonitrile compound, and a structural unit having a polyalkylene oxide structure.

Examples of the acrylonitrile compound include acrylonitrile, methacrylonitrile, and the like. Among these, acrylonitrile is preferable.

Examples of the aromatic vinyl compound include styrene, p-methylstyrene, p-methoxystyrene, β-methylstyrene, p-methyl-β-methylstyrene, α-methylstyrene, and p-methoxy-β-methylstyrene, and styrene is preferable.

In the polymer particles having a structural unit formed of an aromatic vinyl compound and a structural unit formed of an acrylonitrile compound, a compositional ratio (mass ratio) between the structural unit formed of an aromatic vinyl compound and the structural unit formed of an acrylonitrile compound is preferably 10:1 to 1:10.

From the viewpoint of printing durability and developing residue suppressing property, the polyalkylene oxide structure in the structural unit having a polyalkylene oxide structure is preferably a polyethylene oxide structure, a polypropylene oxide structure, or a polyethylene/propylene oxide structure, and more preferably a polyethylene oxide structure.

From the viewpoint of on-press developability printing durability and developing residue suppressing property, the number of repeating of the alkylene oxide structure in the polyalkylene oxide structure is preferably 2 to 100 and more preferably 3 to 55.

From the viewpoint of printing durability and developing residue suppressing property, the content of the structural unit formed of an acrylonitrile compound in the polymer particles in the first embodiment of the lithographic printing plate precursor according to the present disclosure is preferably 20% by mass to 95% by mass, more preferably 50% by mass to 95% by mass, still more preferably 70% by mass to 90% by mass, and particularly preferably 75% by mass to 90% by mass with respect to the total mass of the polymer having a structural unit having a cyano group.

The content of the structural unit formed of an acrylonitrile compound in the polymer particles in the second embodiment of the lithographic printing plate precursor according to the present disclosure is 65% by mass or more, and from the viewpoint of printing durability and developing residue suppressing property, the content is preferably 70% by mass to 95% by mass, more preferably 70% by mass to 90% by mass, and particularly preferably 75% by mass to 90% by mass with respect to the total mass of the polymer having a structural unit having a cyano group.

From the viewpoint of dispersibility, printing durability, and developing residue suppressing property, the content of the structural unit having a polyalkylene oxide structure in the polymer particles in the first embodiment of the lithographic printing plate precursor according to the present disclosure is preferably 1% by mass to 50% by mass, more preferably 5% by mass to 30% by mass, still more preferably 8% by mass to 25% by mass, and particularly preferably 10% by mass to 20% by mass with respect to the total mass of the polymer particles.

The content of the structural unit having a polyalkylene oxide structure in the polymer particles in the second embodiment of the lithographic printing plate precursor according to the present disclosure is 10% by mass or more, and from the viewpoint of dispersibility, printing durability, and developing residue suppressing property, the content is preferably 10% by mass to 50% by mass, more preferably 10% by mass to 30% by mass, still more preferably 10% by mass to 25% by mass, and particularly preferably 10% by mass to 20% by mass with respect to the total mass of the polymer particles.

From the viewpoint of printing durability and developing residue suppressing property, the content of the structural unit formed of an aromatic vinyl compound in the polymer particles in the first embodiment of the lithographic printing plate precursor according to the present disclosure is preferably 50% by mass or less, more preferably 30% by mass or less, still more preferably 20% by mass or less, and particularly preferably 5% by mass to 20% by mass with respect to the total mass of the polymer particles.

From the viewpoint of printing durability and developing residue suppressing property, the content of the structural unit formed of an aromatic vinyl compound in the polymer particles in the second embodiment of the lithographic printing plate precursor according to the present disclosure is preferably 25% by mass or less, more preferably 20% by mass or less, and particularly preferably 5% by mass to 20% by mass with respect to the total mass of the polymer particles.

From the viewpoint of printing durability and chemical resistance, the polymer particles may have a structural unit formed of an N-vinyl heterocyclic compound.

Examples of the N-vinyl heterocyclic compound include N-vinylpyrrolidone, N-vinylcarbazole, N-vinylpyrrole, N-vinylphenothiazine, N-vinylsuccinic acid imide, N-vinylphthalimide, N-vinylcaprolactam, and N-vinylimidazole. Among these, N-vinylpyrrolidone is preferable.

From the viewpoint of printing durability and chemical resistance, the content of the structural unit formed of an N-vinyl heterocyclic compound in the polymer particles in the first embodiment of the lithographic printing plate precursor according to the present disclosure is preferably 5% by mass to 50% by mass, and more preferably 10% by mass to 40% by mass with respect to the total mass of the polymer particles.

From the viewpoint of printing durability and chemical resistance, the content of the structural unit formed of an N-vinyl heterocyclic compound in the polymer particles in the second embodiment of the lithographic printing plate precursor according to the present disclosure is preferably 5% by mass to 25% by mass, and more preferably 10% by mass to 20% by mass with respect to the total mass of the polymer particles.

The polymer particles may contain a structural unit having an acidic group, but from the viewpoint of on-press developability and ink receptivity, it is preferable that the polymer particles do not contain a structural unit having an acidic group.

Specifically, in the thermoplastic resin, the content of the acidic group-containing structural unit is preferably 20% by mass or less, more preferably 10% by mass or less, and even more preferably 5% by mass or less. The lower limit of the content is not particularly limited, and may be 0% by mass.

The acid value of the thermoplastic resin is preferably 160 mg KOH/g or less, more preferably 80 mg KOH/g or less, and even more preferably 40 mg KOH/g or less. The lower limit of the acid value is not particularly limited, and may be 0 mg KOH/g.

In the present disclosure, the acid value is determined by the measurement method based on JIS K0070: 1992.

From the viewpoint of ink receptivity, the polymer particles may contain a structural unit having a hydrophobic group.

Examples of the hydrophobic group include an alkyl group, an aryl group, an aralkyl group, and the like.

As the hydrophobic group-containing structural unit, a structural unit formed of an alkyl (meth)acrylate compound, an aryl (meth)acrylate compound, or an aralkyl (meth)acrylate compound is preferable, and a structural unit formed of an alkyl (meth)acrylate compound is more preferable.

The alkyl group in the alkyl (meth)acrylate compound preferably has 1 to 10 carbon atoms. The alkyl group may be linear or branched or may have a cyclic structure. Examples of the alkyl (meth)acrylate compound include methyl (meth)acrylate, ethyl (meth)acrylate, propyl (meth)acrylate, cyclohexyl (meth)acrylate, 2-ethylhexyl (meth)acrylate, dicyclopentanyl (meth)acrylate, and the like.

The aryl group in the aryl (meth)acrylate compound preferably has 6 to 20 carbon atoms. The aryl group is more preferably a phenyl group. The aryl group may further have a known substituent. Preferred examples of the aryl (meth)acrylate compound include phenyl (meth)acrylate.

The alkyl group in the aralkyl (meth)acrylate compound preferably has 1 to 10 carbon atoms. The alkyl group may be linear or branched or may have a cyclic structure. The aryl group in the aralkyl (meth)acrylate compound preferably has 6 to 20 carbon atoms. The aryl group is more preferably a phenyl group. Preferred examples of the aralkyl (meth)acrylate compound include benzyl (meth)acrylate.

In the polymer particles in the first embodiment of the lithographic printing plate precursor according to the present disclosure, the content of the structural unit having a hydrophobic group is preferably 5% by mass to 50% by mass, and more preferably 10% by mass to 30% by mass with respect to the total mass of the polymer particles.

In the polymer particles in the second embodiment of the lithographic printing plate precursor according to the present disclosure, the content of the structural unit having a hydrophobic group is preferably 5% by mass to 25% by mass, and more preferably 10% by mass to 20% by mass with respect to the total mass of the polymer particles.

From the viewpoint of printing durability and on-press developability, the resin contained in the polymer particles may have a hydrophilic group other than the polyalkylene oxide structure.

The hydrophilic group is not particularly limited as long as it has a hydrophilic structure, and examples thereof include an acid group such as a carboxy group, a hydroxy group, and an amino group.

In the polymer particles in the first embodiment of the lithographic printing plate precursor according to the present disclosure, the content of the structural unit having a hydrophilic group other than the polyalkylene oxide structure is preferably 1% by mass to 60% by mass, and more preferably 5% by mass to 30% by mass with respect to the total mass of the polymer particles.

In the polymer particles in the second embodiment of the lithographic printing plate precursor according to the present disclosure, the content of the structural unit having a hydrophilic group other than the polyalkylene oxide structure is preferably 1% by mass to 25% by mass, and more preferably 5% by mass to 20% by mass with respect to the total mass of the polymer particles.

A method for producing the resin contained in the polymer particles is not particularly limited, and the resin can be produced by a known method.

For example, the resin can be obtained by polymerizing a styrene compound, an acrylonitrile compound, and at least one compound selected from the group consisting of the N-vinyl heterocyclic compound, the compound used for forming the structural unit having an acidic group, the compound used for forming the structural unit having a hydrophobic group, and the compound used for forming the other structural units, as necessary, by a known method.

In addition, the polyalkylene oxide structure may be introduced by using a monomer having a polyalkylene oxide structure or by a polymer reaction.

Specific examples of the resin contained in the polymer particles are shown in the following table, but the resin used in the present disclosure is not limited thereto.

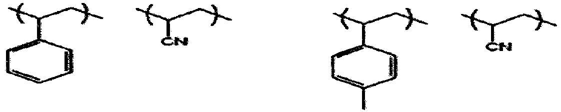

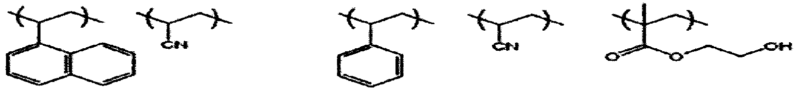

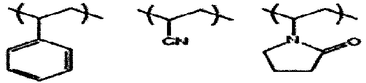

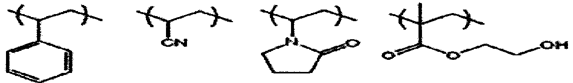

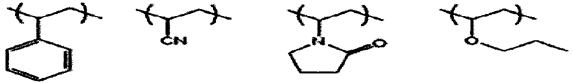

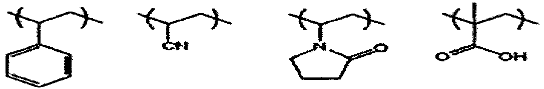

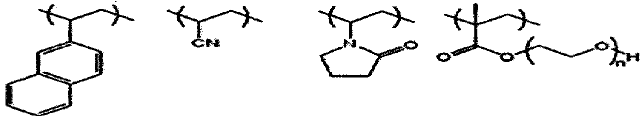

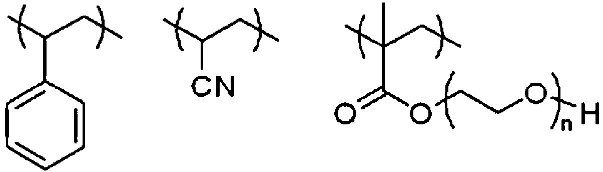

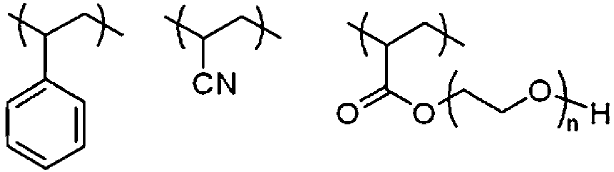

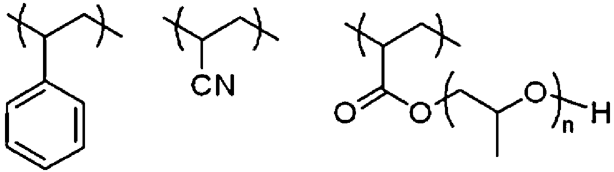

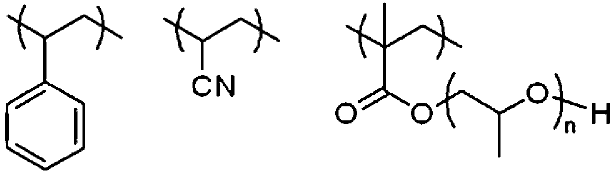

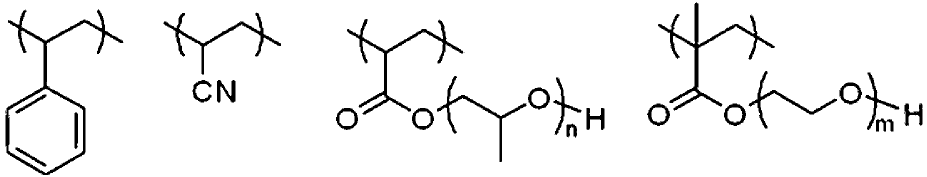

The content ratio of the structural units in the above specific examples can be appropriately changed according to the preferred range of the content of each of the structural units described above.

Furthermore, the weight-average molecular weight of each of the compounds shown in the above specific examples can be appropriately changed according to the preferred range of the weight-average molecular weight of the thermoplastic resin described above.

### [Polymerizable compound]

The image recording layer contains a polymerizable compound.

In the present disclosure, the polymerizable compound refers to a compound having a polymerizable group.

The polymerizable group is not particularly limited and may be a known polymerizable group. As the polymerizable group, an ethylenically unsaturated group is preferable. The polymerizable group may be a radically polymerizable group or a cationically polymerizable group. The polymerizable group is preferably a radically polymerizable group.

Examples of the radically polymerizable group include a (meth)acryloyl group, an allyl group, a vinylphenyl group, a vinyl group, and the like. From the viewpoint of reactivity, a (meth)acryloyl group is preferable.

The molecular weight of the polymerizable compound (weight-average molecular weight in a case where the polymerizable compound has molecular weight distribution) is preferably 50 or more and less than 2,500.

The polymerizable compound may be, for example, a radically polymerizable compound or a cationically polymerizable compound. As the polymerizable compound, an addition polymerizable compound having at least one ethylenically unsaturated bond (ethylenically unsaturated compound) is preferable.

The ethylenically unsaturated compound is preferably a compound having at least one ethylenically unsaturated bond on a terminal, and more preferably a compound having two or more ethylenically unsaturated bonds on a terminal. The chemical form of the polymerizable compound is, for example, a monomer, a prepolymer which is in other words a dimer, a trimer, or an oligomer, a mixture of these, or the like.

Particularly, from the viewpoint of printing durability, the polymerizable compound preferably includes a polymerizable compound having functionalities of 3 or more, more preferably includes a polymerizable compound having functionalities of 7 or more, and even more preferably includes a polymerizable compound having functionalities of 10 or more. Particularly, from the viewpoint of printing durability of the lithographic printing plate to be obtained, the polymerizable compound preferably includes an ethylenically unsaturated compound having functionalities of 3 or more (preferably having functionalities of 7 or more and more preferably having functionalities of 10 or more), and more preferably includes a (meth)acrylate compound having functionalities of 3 or more (preferably having functionalities of 7 or more and more preferably having functionalities of 10 or more).

From the viewpoint of on-press developability and contamination suppressiveness, the aforementioned polymerizable compound preferably includes a polymerizable compound having functionalities of 2 or less, more preferably includes a difunctional polymerizable compound, and particularly preferably includes a difunctional (meth)acrylate compound.

From the viewpoints of printing durability, on-press developability, and contamination suppressiveness, the content of the polymerizable compound having functionalities of 2 or less (preferably a difunctional polymerizable compound) with respect to the total mass of polymerizable compounds in the image recording layer is preferably 5% by mass to 100% by mass, more preferably 10% by mass to 100% by mass, and particularly preferably 15% by mass to 100% by mass.

### -Oligomer-

As the polymerizable compound to be incorporated into in the image recording layer, a polymerizable compound which is an oligomer (hereinafter, also simply called "oligomer") is preferable.

In the present disclosure, an oligomer represents a polymerizable compound which has a molecular weight (weight-average molecular weight in a case where the compound has molecular weight distribution) of 600 or more and 10,000 or less and at least one polymerizable group.

From the viewpoints of excellent chemical resistance and excellent printing durability, the molecular weight of the oligomer is preferably 1,000 or more and 5,000 or less.

In addition, from the viewpoint of improving printing durability, the number of polymerizable groups in one molecule of the oligomer is preferably 2 or more, more preferably 3 or more, even more preferably 6 or more, and particularly preferably 10 or more.

The upper limit value of the polymerizable groups in the oligomer is not particularly limited, but the number of polymerizable groups is preferably 20 or less.

From the viewpoints of printing durability and on-press developability, an oligomer having 7 or more polymerizable groups and a molecular weight of 1,000 or more and 10,000 or less is preferable, and an oligomer having 7 or more and 20 or less polymerizable groups and a molecular weight of 1,000 or more and 5,000 or less is more preferable.

The oligomer may contain a polymer component which is likely to be generated in the process of manufacturing the oligomer.

From the viewpoint of UV printing durability, visibility, and on-press developability, the oligomer preferably has at least one compound selected from the group consisting of a compound having a urethane bond, a compound having an ester bond, and a compound having an epoxy residue, and more preferably has a compound having a urethane bond.

In the present disclosure, an epoxy residue refers to a structure formed of an epoxy group. For example, the epoxy residue means a structure similar to a structure established by the reaction between an acid group (carboxylic acid group or the like) and an epoxy group.

As the compound having a urethane bond, which is an example of the oligomer, for example, a compound having at least a group represented by Formula (Ac-1) or Formula (Ac-2) is preferable, and a compound having at least a group represented by Formula (Ac-1) is more preferable.

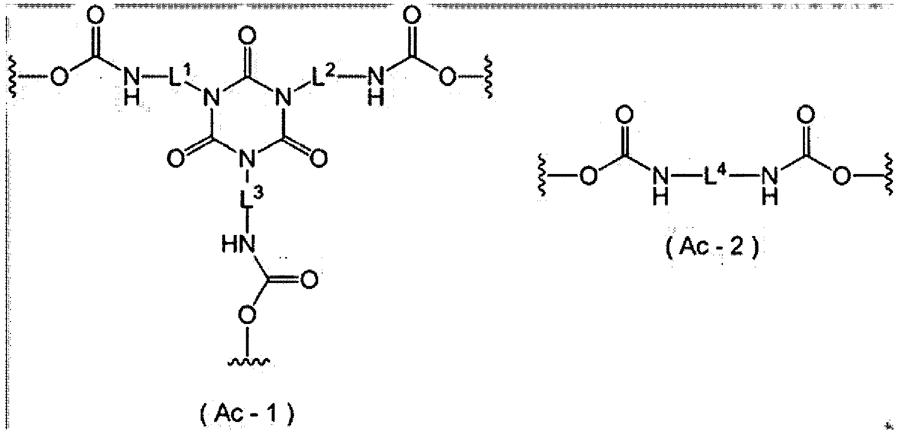

In Formula (Ac-1) and Formula (Ac-2), L¹ to L⁴ each independently represent a divalent hydrocarbon group having 2 to 20 carbon atoms, and the portion of the wavy line represents a binding position binding to other structures.

L¹ to L⁴ preferably each independently represent an alkylene group having a carbon number of 2 to 20, more preferably each independently represent an alkylene group having a carbon number of 2 to 10, and even more preferably each independently represent an alkylene group having a carbon number of 4 to 8. The alkylene group may have a branched structure or a ring structure. The alkylene group is preferably a linear alkylene group.

The portion of the wavy line in Formula (Ac-1) or Formula (Ac-2) is preferably each independently directly bonded to the portion of the wavy line in a group represented by Formula (Ae-1) or Formula (Ae-2).

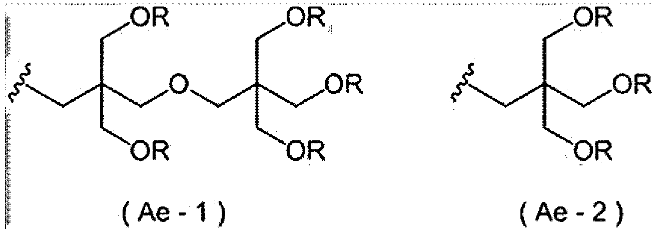

In Formula (Ae-1) and Formula (Ae-2), R each independently represent an acryloyloxy group or a methacryloyloxy group, and the portion of the wavy line represents a position binding to the portion of the wavy line in Formula (Ac-1) and Formula (Ac-2).

In addition, as the compound having a urethane bond, a compound which is prepared by obtaining polyurethane by a reaction between a polyisocyanate compound and a polyol compound and introducing a polymerizable group into the obtained polyurethane by a polymer reaction may also be used.

For example, the compound having a urethane bond may be obtained by reacting a polyol compound having an acid group with a polyisocyanate compound to obtain a polyurethane oligomer and reacting the obtained polyurethane oligomer with a compound having an epoxy group and a polymerizable group.

The number of polymerizable groups in the compound having an ester bond, which is an example of oligomer, is preferably 3 or more, and more preferably 6 or more.

As the compound having an epoxy residue, which is an example of the oligomer, a compound containing a hydroxy group in the compound is preferable.

The number of polymerizable groups in the compound having an epoxy residue is preferably 2 to 6, and more preferably 2 or 3.

The above-described compound having an epoxy residue can be obtained, for example, by reacting a compound having an epoxy group with an acrylic acid.

Specific examples of oligomers will be shown as follows, but the oligomer used in the present disclosure is not limited thereto.

As the oligomer, commercially available products may also be used. Examples thereof include UA510H, UA-306H, UA-306I, and UA-306T (manufactured by KYOEISHA CHEMICAL Co., LTD.), UV-1700B, UV-6300B, and UV7620EA (manufactured by The Nippon Synthetic Chemical Industry Co., Ltd.), U-15HA (manufactured by SHIN-NAKAMURA CHEMICAL Co., LTD.), EBECRYL450, EBECRYL657, EBECRYL885, EBECRYL800, EBECRYL3416, and EBECRYL860 (manufactured by DAICEL-ALLNEX LTD.), and the like. However, the oligomer is not limited to these.

From the viewpoint of improving chemical resistance and printing durability and further suppressing the residues of on-press development, the content of the oligomer with respect to the total mass of polymerizable compounds in the image recording layer is preferably 30% by mass to 100% by mass, more preferably 50% by mass to 100% by mass, and even more preferably 80% by mass to 100% by mass.

### -Low-molecular-weight polymerizable compound-

The polymerizable compound may further include a polymerizable compound other than the above-described oligomer.

From the viewpoint of chemical resistance, the polymerizable compound other than the oligomer is preferably a low-molecular-weight polymerizable compound. The low-molecular-weight polymerizable compound may take a chemical form such as a monomer, a dimer, a trimer, or a mixture of these.

From the viewpoint of chemical resistance, the low-molecular-weight polymerizable compound is preferably at least one polymerizable compound selected from the group consisting of a polymerizable compound having three or more ethylenically unsaturated groups and a polymerizable compound having an isocyanuric ring structure.

In the present disclosure, a low-molecular-weight polymerizable compound refers to a polymerizable compound having a molecular weight (weight-average molecular weight in a case where the compound has molecular weight distribution) of 50 or more and less than 600.

From the viewpoints of excellent chemical resistance, excellent printing durability, and excellently suppressing the residues of on-press development, the molecular weight of the low-molecular-weight polymerizable compound is preferably 100 or more and less than 600, more preferably 300 or more and less than 600, and even more preferably 400 or more and less than 600.

In a case where the polymerizable compound includes a low-molecular-weight polymerizable compound as the polymerizable compound other than an oligomer (total amount in a case where the polymerizable compound includes two or more low-molecular-weight polymerizable compounds), from the viewpoint of chemical resistance and printing durability and suppressing the residues of on-press development, the ratio of the oligomer to the low-molecular-weight polymerizable compound (oligomer/low-molecular-weight polymerizable compound) is preferably 10/1 to 1/10, more preferably 10/1 to 3/7, and even more preferably 10/1 to 7/3, based on mass.

As the low-molecular-weight polymerizable compound, polymerizable compounds described in paragraphs 0082 to 0086 of WO2019/013268A can also be suitably used.

The details of how to use the polymerizable compound, such as the structure of the compound, whether the compound is used alone or used in combination with other compounds, and the amount of the compound to be added, can be randomly set.

Particularly, from the viewpoint of printing durability, the image recording layer preferably contains two or more polymerizable compounds.

The content of the polymerizable compound (total content of polymerizable compounds in a case where the image recording layer contains two or more kinds of polymerizable compounds) with respect to the total mass of the image recording layer is preferably 5% by mass to 75% by mass, more preferably 10% by mass to 70% by mass, and even more preferably 15% by mass to 60% by mass.

### [Polymerization initiator]

The image recording layer in the present disclosure preferably contains a polymerization initiator.

From the viewpoint of sensitivity, printing durability, on-press developability, and receptivity, the polymerization initiator preferably includes an electron-donating polymerization initiator, and more preferably includes an electron-accepting polymerization initiator and an electron-donating polymerization initiator.

### -Electron-accepting polymerization initiator-

It is preferable that the image recording layer contain an electron-accepting polymerization initiator as a polymerization initiator.

The electron-accepting polymerization initiator is a compound which accepts one electron by intermolecular electron migration in a case where electrons of an infrared absorber are excited by exposure to infrared rays, and generates a polymerization initiation species such as radicals.

The electron-accepting polymerization initiator used in the present disclosure is a compound that generates a polymerization initiation species such as a radical or a cation by either or both of light energy and heat energy, and can be appropriately selected from known thermal polymerization initiators, compounds having a bond that requires low bond dissociation energy, photopolymerization initiators, and the like.

The electron-accepting polymerization initiator is preferably a radical polymerization initiator and more preferably an onium salt compound.

In addition, as the electron-accepting polymerization initiator, an infrared-ray-sensitive polymerization initiator is preferable.

Examples of the electron-accepting radical polymerization initiator include (a) organic halide, (b) carbonyl compound, (c) azo compound, (d) organic peroxide, (e) metallocene compound, (f) azide compound, (g) hexaarylbiimidazole compound, (i) disulfone compound, (j) oxime ester compound, and (k) onium salt compound.

As (a) organic halide, for example, the compounds described in paragraphs "0022" and" 0023" of JP2008-195018A are preferable.

As (b) carbonyl compound, for example, the compounds described in paragraph "0024" of JP2008-195018A are preferable.

As (c) azo compound, for example, the azo compounds described in JP1996-108621A (JP-H8-108621A) and the like can be used.

As (d) organic peroxide, for example, the compounds described in paragraph "0025" of JP2008-195018A are preferable.

As (e) metallocene compound, for example, the compounds described in paragraph "0026" of JP2008-195018A are preferable.

Examples of (f) azide compound include compounds such as 2,6-bis(4-azidobenzylidene)-4-methylcyclohexanone.

As (g) hexaarylbiimidazole compound, for example, the compounds described in paragraph "0027" of JP2008-195018A are preferable.

Examples of (i) disulfone compound include the compounds described in JP1986-166544A (JP-S61-166544A) and JP2002-328465A.

As (j) oxime ester compound, for example, the compounds described in paragraphs "0028" to "0030" of JP2008-195018A are preferable.

Among the above electron-accepting polymerization initiators, from the viewpoint of curing properties, an oxime ester compound and an onium salt compound are preferable. Particularly, from the viewpoint of printing durability, an iodonium salt compound, a sulfonium salt compound, or an azinium salt compound is preferable, an iodonium salt compound or a sulfonium salt compound is more preferable, and an iodonium salt compound is particularly preferable.

Examples of the iodonium salt compound and the sulfonium salt compound include those described in paragraphs 0060 and 0061 of JP2023-138231A.

As a counteranion of the iodonium salt compound and the sulfonium salt compound, a sulfonamide anion or a sulfonimide anion is preferable, and a sulfonimide anion is more preferable.

As the sulfonamide anion, an arylsulfonamide anion is preferable.

In addition, as the sulfonimide anion, a bisaryl sulfonimide anion is preferable.

Specifically, suitable examples of the sulfonamide anion and the sulfonimide anion include those described in WO2020/262692A.

From the viewpoint of developability and printing durability of the lithographic printing plate to be obtained, the electron-accepting polymerization initiator may include a compound represented by Formula (II).

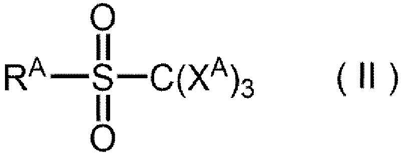

In Formula (II), X^{A} represents a halogen atom, and R^{A} represents an aryl group.

Specifically, examples of X^{A} in Formula (II) include a fluorine atom, a chlorine atom, a bromine atom, and an iodine atom. Among these, a chlorine atom or a bromine atom is preferable because these have excellent sensitivity, and a bromine atom is particularly preferable.

Furthermore, from the viewpoint of excellent balance between sensitivity and storage stability, R^{A} in Formula (II) is preferably an aryl group substituted with an amide group.

As a specific example of the electron-accepting polymerization initiator represented by Formula (II), those described in WO2020/262692A can be suitably used.

From the viewpoint of improving sensitivity and making it difficult for plate missing to occur, the lowest unoccupied molecular orbital (LUMO) of the electron-accepting polymerization initiator is preferably -3.00 eV or less, and more preferably -3.02 eV or less.

The lower limit of LUMO is preferably -3.80 eV or more, and more preferably -3.60 eV or more.

One electron-accepting polymerization initiator may be used alone, or two or more electron-accepting polymerization initiators may be used in combination.

The content of the electron-accepting polymerization initiator with respect to the total mass of the image recording layer is preferably 0.1% by mass to 50% by mass, more preferably 0.5% by mass to 30% by mass, and particularly preferably 0.8% by mass to 20% by mass.

### -Electron-donating polymerization initiator-

The polymerization initiator preferably further includes an electron-donating polymerization initiator, and more preferably includes both the electron-donating polymerization initiator and the electron-donating polymerization initiator described above, because such a polymerization initiator contributes to the improvement of chemical resistance and printing durability of the lithographic printing plate.

Examples of the electron-donating polymerization initiator include the following five kinds of initiators.
(i) Alkyl or arylate complex: it is considered that a carbon-hetero bond is oxidatively cleaved, and an active radical is generated. Specific examples thereof include a borate salt compound.
(ii) Aminoacetic acid compound: it is considered that a C-X bond on carbon adjacent to a nitrogen is cleaved by oxidation, and an active radical is generated. As X, a hydrogen atom, a carboxy group, a trimethylsilyl group, or a benzyl group is preferable; specific examples thereof include N-phenylglycines (which may have a substituent in a phenyl group.) and N-phenyl iminodiacetic acids (which may have a substituent in a phenyl group).
(iii) Sulfur-containing compound: compound obtained by substituting nitrogen atoms of the aforementioned amino acetate compound with sulfur atoms and capable of generating active radicals by the same action as that of the amino acetate compound. Specific examples thereof include phenylthioacetic acid (which may have a substituent on a phenyl group).
(iv) Compound: Tin-containing compound: compound obtained by substituting nitrogen atoms of the aforementioned amino acetate compound with tin atoms and capable of generating active radicals by the same action as that of the amino acetate compound.
(v) Sulfinates: an active radical can be generated by oxidation. Specific examples thereof include sodium aryl sulfinate and the like.

It is preferable that the image recording layer contain the borate salt compound among the above electron-donating polymerization initiators. As the borate salt compound, a tetraaryl borate salt compound or a monoalkyltriaryl borate salt compound is preferable. From the viewpoint of compound stability, a tetraaryl borate salt compound is more preferable, and a tetraphenyl borate salt compound is particularly preferable.

A countercation that the borate compound has is not particularly limited, but is preferably an alkali metal ion or a tetraalkyl ammonium ion and more preferably a sodium ion, a potassium ion, or a tetrabutylammonium ion.

Specifically, preferred examples of the borate salt compound include sodium tetraphenyl borate.

From the viewpoint of chemical resistance and printing durability, the highest occupied molecular orbital (HOMO) of the electron-donating polymerization initiator used in the present disclosure is preferably -6.00 eV or more, more preferably -5.95 eV or more, even more preferably -5.93 eV or more, and particularly preferably more than -5.90 eV.

The upper limit of the energy level of HOMO is preferably -5.00 eV or less, and more preferably -5.40 eV or less.

Specifically, preferred examples of the electron-donating polymerization initiator suitably include the electron-donating polymerization initiator described in WO2020/262692A.

From the viewpoint of visibility, printing durability, and temporal stability, the image recording layer preferably contains an onium salt compound as the electron-accepting polymerization initiator and contains at least one kind of compound selected from the group consisting of borate salt compounds as the electron-donating polymerization initiator, and more preferably contains an onium salt compound as the electron-accepting polymerization initiator and contains a borate salt compound as the electron-donating polymerization initiator.

Furthermore, the image recording layer preferably contains a borate salt compound as the electron-donating polymerization initiator. The image recording layer more preferably contains a borate salt compound as the electron-donating polymerization initiator, and HOMO of the infrared absorber - HOMO of the borate salt compound is more preferably equal to or less than 0.70 eV.

Only one kind of electron-donating polymerization initiator may be added to the image recording layer, or two or more kinds of electron-donating polymerization initiators may be used in combination.

The content of the electron-donating polymerization initiator with respect to the total mass of the image recording layer is preferably 0.01% by mass to 30% by mass, more preferably 0.05% by mass to 25% by mass, and even more preferably 0.1% by mass to 20% by mass.

One of the preferred aspects of the present disclosure is an aspect in which the aforementioned electron-accepting polymerization initiator and the aforementioned electron-donating polymerization initiator form a salt.

Specific examples thereof include an aspect in which the aforementioned onium salt compound is a salt formed of an onium ion and an anion of the electron-donating polymerization initiator (for example, a tetraphenyl borate anion). In addition, for example, an iodonium borate salt compound is more preferable which is a salt formed of an iodonium cation of the aforementioned iodonium salt compound (for example, a di-p-tolyl iodonium cation) and a borate anion of the aforementioned electron-donating polymerization initiator.

Specific examples of the aspect in which the electron-accepting polymerization initiator and the electron-donating polymerization initiator form a salt suitably include those described in WO2020/262692A.

In the present disclosure, in a case where the image recording layer contains an onium ion and an anion of the aforementioned electron-donating polymerization initiator, the image recording layer is regarded as containing an electron-accepting polymerization initiator and the electron-donating polymerization initiator described above.

### [Infrared absorber]

It is also preferable that the image recording layer in the present disclosure contains an infrared absorber.

The infrared absorber is not particularly limited, and examples thereof include pigments and dyes.

As the dye that is used as the infrared absorber, it is possible to use commercially available dyes and known dyes described in publications, for example, "Dye Handbooks" (edited by the Society of Synthetic Organic Chemistry, Japan, 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among these dyes, for example, a cyanine dye, a squarylium colorant, a pyrylium salt, a nickel thiolate complex, and an indolenine cyanine dye are particularly preferable. Furthermore, for example, a cyanine colorant or an indolenine cyanine colorant is preferable. Among these, a cyanine dye is particularly preferable.

The infrared absorber is preferably a cationic polymethine colorant having an oxygen or nitrogen atom at the meso-position. Preferred examples of the cationic polymethine colorant include a cyanine dye, a pyrylium colorant, a thiopyrylium colorant, an azulenium colorant, and the like. From the viewpoint of ease of availability, solubility in a solvent during an introduction reaction, and the like, a cyanine dye is preferable.

Specific examples of the cyanine colorant include the compounds described in paragraphs "0017" to "0019" of JP2001-133969A and the compounds described in paragraphs "0016" to "0021" of JP2002-023360A and paragraphs "0012" to "0037" of JP2002-040638A. As the cyanine colorant, for example, the compounds described in paragraphs "0034" to "0041" of JP2002-278057A and paragraphs "0080" to "0086" of JP2008-195018A are preferable, and the compounds described in paragraphs "0035" to "0043" of JP2007-90850A and the compounds described in paragraphs "0105" to "0113" of JP2012-206495A are particularly preferable.

Furthermore, the compounds described in paragraphs "0008" and "0009" of JP1993-5005A (JP-H05-5005A) and paragraphs "0022" to "0025" of JP2001-222101A can also be preferably used.

As the pigment, a compound described in paragraphs 0072 to 0076 of JP2008-195018A is preferable.

In addition, the infrared absorber may include an infrared absorber that decomposes upon exposure to infrared (decomposable infrared absorber). Examples of the decomposable infrared absorber include a decomposable color-forming infrared absorber.

Presumably, in a case where a decomposition-type infrared absorber is used as the infrared absorber, the infrared absorber or a decomposition product thereof may promote polymerization, and the decomposition product of the infrared absorber and the polymerizable compound may interact with each other, which may result in excellent printing durability.

The decomposition-type infrared absorber is preferably an infrared absorber that performs a function of forming color by absorbing infrared and decomposing by exposure to infrared.

Hereinafter, a color-developing compound formed as a result of infrared absorption and decomposition of the decomposition-type infrared absorber by exposure to infrared will be also called "color developing substance of the decomposition-type infrared absorber".

Furthermore, it is preferable that the decomposition-type infrared absorber have a function of absorbing infrared by exposure to infrared and converting the absorbed infrared into heat.

The decomposition-type infrared absorber may be an infrared absorber that decomposes by absorbing at least a part of light in the infrared wavelength region (wavelength of 750 nm to 1 mm). The decomposition-type infrared absorber is preferably an infrared absorber having a maximal absorption wavelength in a wavelength region of 750 nm to 1,400 nm, and more preferably an infrared absorber having a maximal absorption wavelength in a wavelength region of 760 nm to 900 nm.

More specifically, the decomposition-type infrared absorber is preferably a compound that decomposes due to the exposure to infrared and generates a compound having maximum absorption wavelength in a wavelength region of 500 nm to 600 nm.

The decomposition-type infrared absorber is preferably an infrared absorber that decomposes by either or both of heat and electron migration resulting from exposure to infrared, and more preferably an infrared absorber that decomposes by electron migration resulting from exposure to infrared. "Decomposes by electron migration" mentioned herein means that electrons excited to the lowest unoccupied molecular orbital (LUMO) from the highest occupied molecular orbital (HOMO) of the decomposition-type infrared absorber by exposure to infrared move to electron accepting groups (groups having potential close to LUMO) in a molecule by means of intramolecular electron migration and thus result in decomposition.

In addition, from the viewpoint of color formability, the infrared absorber preferably includes a compound represented by Formula (X) as a decomposition-type infrared absorber.

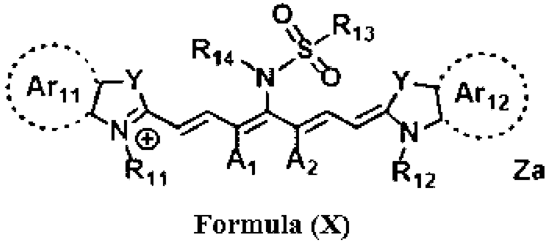

In Formula (X), Ar₁₁ and Ar₁₂ each independently represent an atomic group necessary for forming a substituted or unsubstituted aromatic ring or for forming a substituted or unsubstituted heteroaromatic ring, R₁₁ and R₁₂ each independently represent a substituted or unsubstituted alkyl group, R₁₃ represents a substituted or unsubstituted alkyl group, a substituted or unsubstituted aryl group, or a substituted or unsubstituted heteroaryl group, R₁₄ represents a hydrogen atom, a substituted or unsubstituted alkyl group, a substituted or unsubstituted aryl group, or a substituted or unsubstituted heteroaryl group, Y's each independently represent an oxygen atom, a sulfur atom, or a dialkylmethylene group represented by >C(R₁₅R₁₆), R₁₅ and R₁₆ each independently represent a substituted or unsubstituted alkyl group having 1 to 4 carbon atoms, A₁ and A₂ each independently represent a substituted or unsubstituted alkyl group or represent an atomic group including 2 or 3 carbon atoms necessary for forming a substituted or unsubstituted 5- or 6-membered non-aromatic carbon ring by linking to each other, and Za represents a counter ion that neutralizes an electric charge.

Ar₁₁ and Ar₁₂ each independently represent an atomic group necessary for forming a substituted or unsubstituted aromatic ring or a substituted or unsubstituted heteroaromatic ring, and examples of a substituent of the aromatic ring or the heteroaromatic ring include an alkyl group, an alkoxy group, a halogen atom, a cyano group, a -COOR group, a -SO₃R group, or a - SO₂R group (R represents a substituted or unsubstituted alkyl group), and an alkyl group or a halogen atom is preferable.

In addition, Ar₁₁ and Ar₁₂ are preferably an atomic group necessary for forming a substituted or unsubstituted aromatic ring, and more preferably an atomic group necessary for forming a substituted or unsubstituted benzene ring or naphthalene ring.

Y's each independently preferably represent a dialkylmethylene group represented by >C(R₁₅R₁₆), and preferably a dialkylmethylene group represented by >C(R₁₅R₁₆) in which R₁₅ and R₁₆ are the same. In this case, it is preferable that R₁₅ and R₁₆ each independently represent a substituted or unsubstituted alkyl group having 1 or 2 carbon atoms.

The above-described Y, in particular, is represented by >C(R₁₅R₁₆), is preferably a dialkylmethylene group in which R₁₅ and R₁₆ are a methyl group.

R₁₁ and R₁₂ are each independently preferably a substituted or unsubstituted alkyl group having 1 to 12 carbon atoms. In addition, R₁₁ and R₁₂ may include an ether bond or an ester bond in the middle of a carbon chain of a substituted or unsubstituted alkyl group having 1 to 12 carbon atoms.

R₁₃ is preferably a substituted or unsubstituted alkyl group having 1 to 12 carbon atoms, and more preferably a haloalkyl group in which one or more of hydrogen atoms of an alkyl group having 1 to 12 carbon atoms are substituted with a halogen atom. In this case, preferred examples of the halogen atom include a chlorine atom and a bromine atom.

Among these, R₁₁ and R₁₂ are each independently preferably a perfluoroalkyl group.

R₁₄ is preferably a hydrogen atom or an unsubstituted alkyl group having 1 or 8 carbon atoms.

It is preferable that A₁ and A₂ each independently represent a substituted or unsubstituted alkyl group, or an atomic group that are bonded to each other and include 2 or 3 carbon atoms necessary for forming a cyclopentene ring or a cyclohexene ring.

In a case where Za is a counteranion, an anion containing a halogen atom or an anion containing a boron atom is preferable. Specific examples of Za include CLO₄⁻, PF₆⁻, BF₄⁻, SbF₆⁻, CH₃SO₃⁻, CF₃SO₃⁻, C₆H₅SO₃⁻, CH₃C₆H₅SO₃⁻, HOC₆H₅SO₃⁻, ClC₆H₅SO₃⁻, CH₃C₆H₅SO₃⁻, and a tetraaryl borate anion (for example, a tetraphenylborate anion).

In a case where Za is a countercation, examples thereof include an alkali metal ion, an alkaline earth metal ion, a tertiary ammonium ion, a quaternary ammonium ion, and an onium ion (an iodonium ion, a sulfonium ion, a phosphonium ion, and the like).

Specific examples of the compound represented by Formula (X) will be shown below. However, the present disclosure is not limited thereto. Ph represents a phenyl group.

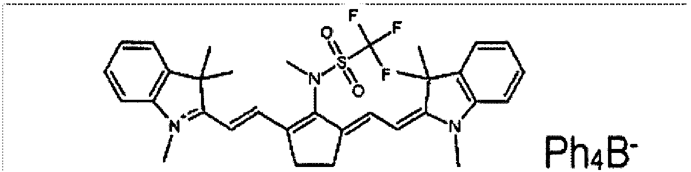

As the infrared absorber and the infrared absorber that decomposes by exposure to infrared, those described in WO2020/262692A can also be suitably used.

As the infrared absorber that decomposes by exposure to infrared, those described in JP2008-544322A or WO2016/027886A can also be suitably used.

In addition, as the cyanine dye which is a decomposition-type infrared absorber, the infrared absorbing compounds described in WO2019/219560A can be suitably used.

One kind of infrared absorber may be used alone, or two or more kinds of infrared absorbers may be used in combination. In one aspect, the image recording layer preferably contains two or more kinds of the infrared absorbers. In addition, as the infrared absorber, the pigment and the dye may be used in combination.

The total content of the infrared absorber in the image recording layer with respect to the total mass of the image recording layer is preferably 0.1% by mass to 10.0% by mass, and more preferably 0.5% by mass to 5.0% by mass.

[Relationship among electron-donating polymerization initiator, electron-accepting polymerization initiator, and infrared absorber]

The image recording layer in the present disclosure preferably contains two or more kinds of electron-donating polymerization initiators, an electron-accepting polymerization initiator, and further contains an infrared absorber.

In a case where the image recording layer contains two or more kinds of electron-donating polymerization initiators, an electron-accepting polymerization initiator, and an infrared absorber, it is more preferable that at least one HOMO of the two or more kinds of electron-donating polymerization initiators is -6.0 eV or more and the LUMO of the electron-accepting polymerization initiator is -3.0 eV or less.

More preferred aspects of the HOMO of the two or more kinds of electron-donating polymerization initiators and the LUMO of the electron-accepting polymerization initiator are as described above, respectively.

In the image recording layer in the present disclosure, it is presumed that at least one of two or more kinds of electron-donating polymerization initiators, an electron-accepting polymerization initiator, and an infrared absorber transfer energy, for example, as described in the following chemical formulae.

Therefore, in a case where at least one HOMO of two or more kinds of electron-donating polymerization initiators is -6.0 eV or more and the LUMO of the electron-accepting polymerization initiator is -3.0 eV or less, the efficiency of generating radicals is improved, and thus it is considered that the chemical resistance and the printing durability are likely to be more excellent.

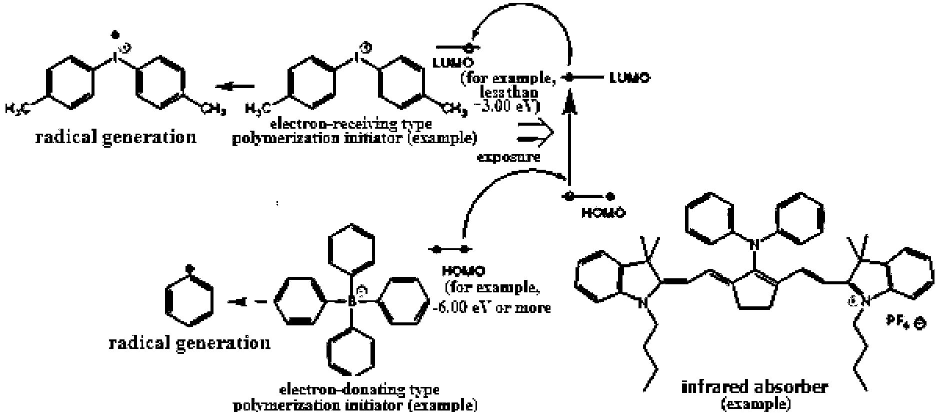

From the viewpoints of UV printing durability and chemical resistance, at least one of the HOMO value of the infrared absorber - the HOMO value of the electron-donating polymerization initiator is preferably 1.0 eV or less, more preferably 0.70 eV or less, and particularly preferably 0.60 eV or less. In addition, from the same viewpoint, the value of HOMO of the infrared absorber - HOMO of at least one kind of the electron-donating polymerization initiator is preferably -0.200 eV or more and more preferably -0.100 eV or more.

The negative value means that the HOMO of at least one kind of the electron-donating polymerization initiator is higher than the HOMO of the infrared absorber.

In addition, from the viewpoint of printing durability and chemical resistance, the value of LUMO of the electron-accepting polymerization initiator - LUMO of the infrared absorber is preferably 1.00 eV or less and more preferably 0.700 eV or less. In addition, from the same viewpoint, the value of LUMO of the electron-accepting polymerization initiator - LUMO of the infrared absorber is preferably -0.200 eV or more and more preferably -0.100 eV or more.

In addition, from the same viewpoint, the value of LUMO of the electron-accepting polymerization initiator - LUMO of the infrared absorber is preferably 1.00 eV to -0.200 eV and more preferably 0.700 eV to -0.100 eV. The negative value means that the LUMO of the infrared absorber is higher than the LUMO of the electron-accepting polymerization initiator.

### [Color forming agent]

The image recording layer preferably contains a color developing agent, and more preferably contains an acid color developing agent.

"Color developing agent" used in the present disclosure means a compound that develops or removes color by a stimulus such as light or acid and thus changes the color of the image recording layer. Furthermore, "acid color forming agent" means a compound that develops or removes color by being heated in a state of accepting an electron accepting compound (for example, a proton of an acid or the like) and thus changes the color of the image recording layer. The acid color forming agent is particularly preferably a colorless compound which has a partial skeleton such as lactone, lactam, sultone, spiropyran, an ester, or an amide and allows such a partial skeleton to rapidly open the ring or to be cleaved when coming into contact with an electron accepting compound.

Examples of such an acid color forming agent include the acid color forming agents described in JP2023-16860A.

Particularly, from the viewpoint of color formability, the color forming agent used in the present disclosure is preferably at least one type of compound selected from the group consisting of a spiropyran compound, a spirooxazine compound, a spirolactone compound, and a spirolactam compound.

From the viewpoint of visibility, the hue of the colorant after color formment is preferably green, blue, or black.

From the viewpoint of color developability and visibility of exposed portions, the acid color developing agent is preferably a leuco colorant.

The leuco colorant is not particularly limited as long as it has a leuco structure. The leuco colorant preferably has a spiro structure, and more preferably has a spirolactone ring structure.

From the viewpoint of color developability and visibility of exposed portions, the leuco colorant is preferably a leuco colorant having a phthalide structure or a fluoran structure.

Furthermore, from the viewpoint of color developability and visibility of exposed portions, the leuco colorant having a phthalide structure or a fluoran structure is preferably a compound represented by any of Formula (Le-1) to Formula (Le-3), and more preferably a compound represented by Formula (Le-2).

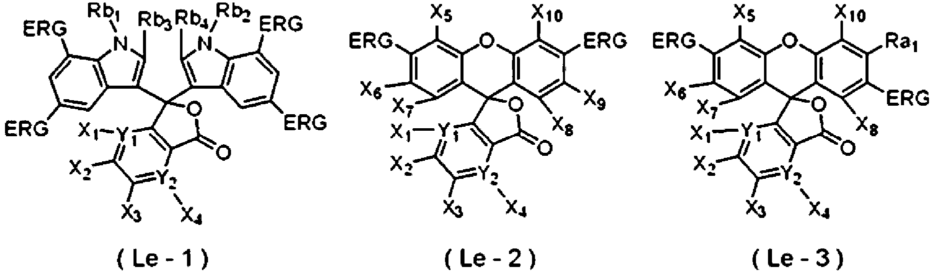

In Formula (Le-1) to Formula (Le-3), ERG each independently represent an electron-donating group, X₁ to X₄ each independently represent a hydrogen atom, a halogen atom, or dialkylanilino group, X₅ to X₁₀ each independently represent a hydrogen atom, a halogen atom, or a monovalent organic group, Y₁ and Y₂ each independently represent C or N, X₁ does not exist in a case where Y₁ is N, X₄ does not exist in a case where Y₂ is N, Ra₁ represents a hydrogen atom, an alkyl group, or an alkoxy group, and Rb₁ to Rb₄ each independently represent a hydrogen atom, an alkyl group, an aryl group, or a heteroaryl group.

From the viewpoints of color formability and visibility of exposed portions, the electron-donating group represented by ERG in Formula (Le-1) to Formula (Le-3) is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, or an aryloxy group, still more preferably a monoalkyl monoarylamino group, a diarylamino group, a diheteroarylamino group, or a monoaryl monoheteroarylamino group, and particularly preferably a monoalkyl monoarylamino group.

From the viewpoint of color developability and visibility of exposed portions, the electron-donating group represented by ERG is preferably a disubstituted amino group having an aryl group that has a substituent on at least one ortho position or a heteroaryl group that has a substituent on at least one ortho position, more preferably a disubstituted amino group having a substituent on at least one ortho position and a phenyl group having an electron-donating group at a para position, even more preferably an amino group having a substituent on at least one ortho position and a phenyl group having an electron-donating group at a para position and an aryl group or a heteroaryl group, and particularly preferably an amino group having a substituent on at least one ortho position, a phenyl group having an electron-donating group at a para position, and an aryl group having an electron-donating group or a heteroaryl group having an electron-donating group.

In the present disclosure, in a case where a bonding position of an aryl group or a heteroaryl group with other structures is defined as 1-position, the ortho position in the aryl group or heteroaryl group other than a phenyl group is called a bonding position (for example, 2-position or the like) adjacent to the 1-position.

Further, from the viewpoint of color developability and visibility of the exposed portion, the electron-donating group included in the aryl group or the heteroaryl group is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoarylo mono heteroarylamino group, an alkoxy group, an aryloxy group, a heteroaryloxy group, or an alkyl group, more preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoarylo mono heteroarylamino group, an alkoxy group, or an aryloxy group, still more preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoarylo mono heteroarylamino group, or an alkoxy group, and particularly preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoarylo mono heteroarylamino group, or an alkoxy group.

The electron-donating group included in the aryl group or the heteroaryl group is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoarylo mono heteroarylamino group, an alkoxy group, an aryloxy group, a heteroaryloxy group, or an alkyl group, more preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoarylo mono heteroarylamino group, an alkoxy group, an aryloxy group, a heteroaryloxy group, or an alkyl group, and particularly preferably an alkoxy group.

From the viewpoints of color formability and visibility of exposed portions, X₁ to X₄ in Formula (Le-1) to Formula (Le-3) each independently are preferably a hydrogen atom or a chlorine atom, and more preferably each independently represent a hydrogen atom.

From the viewpoint of color developability and visibility of exposed portions, X₅ to X₁₀ in Formula (Le-2) or Formula (Le-3) preferably each independently represent a hydrogen atom, a halogen atom, an alkyl group, an aryl group, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, or a cyano group, more preferably each independently represent a hydrogen atom, a halogen atom, an alkyl group, an aryl group, an alkoxy group, or an aryloxy group, even more preferably each independently represent a hydrogen atom, a halogen atom, an alkyl group, or an aryl group, and particularly preferably each independently represent a hydrogen atom.

From the viewpoint of color developability and visibility of exposed portions, it is preferable that at least one of Y₁ or Y₂ in Formula (Le-1) to Formula (Le-3) be C, and it is more preferable that both of Y₁ and Y₂ be C.

From the viewpoint of color developability and visibility of exposed portions, Ra₁ in Formula (Le-1) to Formula (Le-3) is preferably an alkyl group or an alkoxy group, more preferably an alkoxy group, and particularly preferably a methoxy group.

From the viewpoints of color formability and visibility of exposed portions, Rb₁ to Rb₄ in Formula (Le-1) to Formula (Le-3) each independently are preferably a hydrogen atom or an alkyl group, more preferably an alkyl group, and particularly preferably a methyl group.

In addition, from the viewpoints of color formability and visibility of exposed portions, the leuco colorant having a phthalide structure or a fluoran structure is more preferably a compound represented by any of Formula (Le-4) to Formula (Le-6), and still more preferably a compound represented by Formula (Le-5).

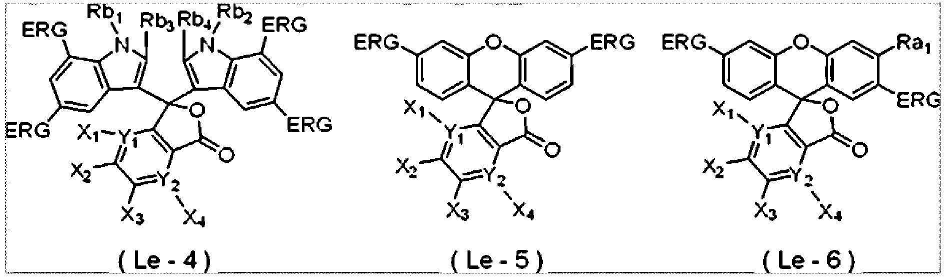

In Formula (Le-4) to Formula (Le-6), ERG each independently represent an electron-donating group, X₁ to X₄ each independently represent a hydrogen atom, a halogen atom, or a dialkylanilino group, Y₁ and Y₂ each independently represent C or N, X₁ does not exist in a case where Y₁ is N, X₄ does not exist in a case where Y₂ is N, Ra₁ represents a hydrogen atom, an alkyl group, or an alkoxy group, and Rb₁ to Rb₄ each independently represent a hydrogen atom, an alkyl group, an aryl group, or a heteroaryl group.

ERG, X₁ to X₄, Y₁, Y₂, Ra₁, and Rb₁ to Rb₄ in Formulae (Le-4) to (Le-6)
have the same meanings as ERG, X₁ to X₄, Y₁, Y₂, Ra₁, and Rb₁ to Rb₄ in Formulae (Le-1) to (Le-3), and preferred aspects thereof are also the same.

Furthermore, from the viewpoints of color formability and visibility of exposed portions, the leuco dye having a phthalide structure or a fluoran structure is even more preferably a compound represented by any of Formula (Le-7) to Formula (Le-9), and particularly preferably a compound represented by Formula (Le-8).

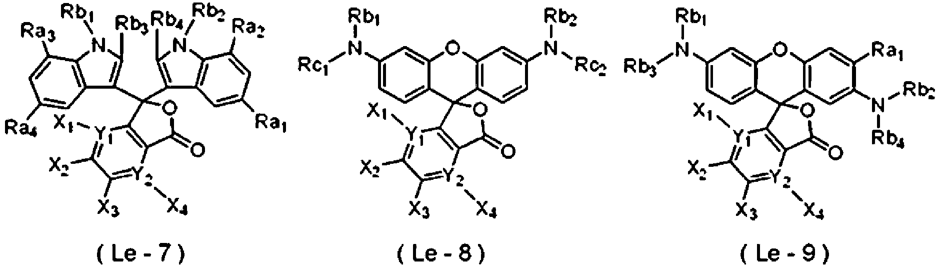

In Formula (Le-7) to Formula (Le-9), X₁ to X₄ each independently represent a hydrogen atom, a halogen atom, or a dialkylanilino group, Y₁ and Y₂ each independently represent C or N, X₁ does not exist in a case where Y₁ is N, X₄ does not exist in a case where Y₂ is N, Ra₁ to Ra₄ each independently represent a hydrogen atom, an alkyl group, or an alkoxy group, Rb₁ to Rb₄ each independently represent a hydrogen atom, an alkyl group, an aryl group, or a heteroaryl group, and Rc₁ and Rc₂ each independently represent an aryl group or a heteroaryl group.

X₁ to X₄, Y₁, and Y₂ in Formula (Le-7) to Formula (Le-9) have the same definition as X₁ to X₄, Y₁, and Y₂ in Formula (Le-1) to Formula (Le-3) respectively, and preferred aspects thereof are also the same.

From the viewpoints of color formability and visibility of exposed portions, Ra₁ to Ra₄ in Formula (Le-7) or Formula (Le-9) each independently are preferably an alkyl group or an alkoxy group, more preferably an alkoxy group, and particularly preferably represent a methoxy group.

From the viewpoint of color developability and visibility of exposed portions, Rb₁ to Rb₄ in Formula (Le-7) to Formula (Le-9) preferably each independently represent a hydrogen atom, an alkyl group, or an aryl group substituted with an alkoxy group, more preferably each independently represent an alkyl group, and particularly preferably each independently represent a methyl group.

From the viewpoint of color developability and visibility of exposed portions, Rc₁ and Rc₂ in Formula (Le-8) preferably each independently represent a phenyl group or an alkylphenyl group, and more preferably each independently represent a phenyl group.

From the viewpoint of color developability and visibility of exposed portions, Rc₁ and Rc₂ in Formula (Le-8) preferably each independently represent an aryl group having a substituent on at least one ortho position or a heteroaryl group having a substituent on at least one ortho position, more preferably each independently represent an aryl group having a substituent on at least one ortho position, even more preferably each independently represent a phenyl group having a substituent on at least one ortho position, and particularly preferably each independently represent a phenyl group having a substituent on at least one ortho position and having an electron-donating group at the para position. Examples of the substituent in Rc₁ and Rc₂ include substituents that will be described later.

In Formula (Le-8), from the viewpoint of color developability and visibility of exposed portions, X₁ to X₄ preferably each represent a hydrogen atom, and Y₁ and Y₂ preferably each represent C.

Furthermore, from the viewpoint of color developability and visibility of exposed portions, in Formula (Le-8), Rb₁ and Rb₂ preferably each independently represent an alkyl group or an aryl group substituted with an alkoxy group.

From the viewpoint of color developability and visibility of exposed portions, Rb₁ and Rb₂ in Formula (Le-8) preferably each independently represent an aryl group or a heteroaryl group, more preferably each independently represent an aryl group, even more preferably each independently represent an aryl group having an electron-donating group, and particularly preferably each independently represent a phenyl group having an electron-donating group at the para position.

From the viewpoints of color formability and visibility of exposed portions, the electron-donating group in Rb₁, Rb₂, Rc₁, and Rc₂ is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an alkoxy group, an aryloxy group, a heteroaryloxy group, or an alkyl group, and particularly preferably an alkoxy group.

In addition, from the viewpoints of the color formability and the visibility of the exposed portion, it is also preferable that the acid color forming agent includes one or more compounds selected from the group consisting of a compound represented by Formula (Le-10) and a compound represented by Formula (Z-4).

That is, it is preferable that the image recording layer in the lithographic printing plate precursor according to the present disclosure further contains one or more compounds selected from the group consisting of a compound represented by Formula (Le-10) and a compound represented by Formula (Z-4).

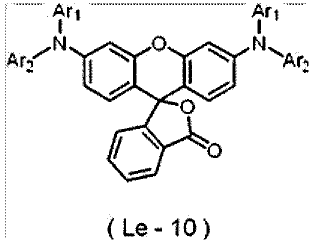

In Formula (Le-10), Ar₁'s each independently represent an aryl group or a heteroaryl group, and Ar₂'s each independently represent an aryl group having a substituent on at least one ortho position or a heteroaryl group having a substituent on at least one ortho position,

Ar₁ in Formula (Le-10) has the same definition as Rb₁ and Rb₂ in Formula (Le-7) to Formula (Le-9), and preferred aspects thereof are also the same.

Ar₂ in Formula (Le-10) has the same definition as Rc₁ and Rc₂ in Formula (Le-7) to Formula (Le-9), and preferred aspects thereof are also the same.

The alkyl group in Formulae (Le-1) to (Le-9) may be linear or branched or may have a ring structure.

The number of carbon atoms in the alkyl group in Formula (Le-1) to Formula (Le-9) is preferably 1 to 20, more preferably 1 to 8, even more preferably 1 to 4, and particularly preferably 1 or 2.

The carbon number of the aryl group in Formula (Le-1) to Formula (Le-10) is preferably 6 to 20, more preferably 6 to 10, and particularly preferably 6 to 8.

Specific examples of the aryl group in Formula (Le-1) to Formula (Le-10) include a phenyl group, a naphthyl group, an anthracenyl group, a phenanthrenyl group, and the like which may have a substituent.

Specific examples of the heteroaryl group in Formula (Le-1) to Formula (Le-10) include a furyl group, a pyridyl group, a pyrimidyl group, a pyrazoyl group, a thiophenyl group, and the like which may have a substituent.

Each of the groups in Formula (Le-1) to Formula (Le-10), such as a monovalent organic group, an alkyl group, an aryl group, a heteroaryl group, a dialkylanilino group, an alkylamino group, and an alkoxy group, may have a substituent. Examples of the substituent include an alkyl group, an aryl group, a heteroaryl group, a halogen atom, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, a cyano group, and the like. In addition, these substituents may be further substituted with these substituents.

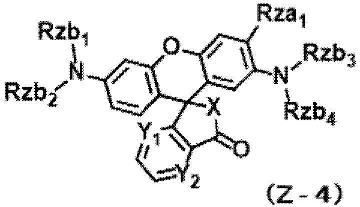

in Formula (Z-4), Rza₁ represents a hydrogen atom, an alkyl group, or an alkoxy group, Rzb₁ to Rzb₄ each independently represent a hydrogen atom, an alkyl group, or an aryl group, Rzb₁ and Rzb₂, and Rzb₃ and Rzb₄ may be linked to each other to form a ring structure, X represents O or NR, R represents a hydrogen atom, an alkyl group, an aryl group, or a heteroaryl group, and Y₁ and Y₂ each independently represent CH or N.

Rza₁ in Formula (Z-4) is preferably an alkyl group or an alkoxy group.

Rzb₁ and Rzb₂ in Formula (Z-4) are each independently preferably an alkyl group.

Rzb₃ and Rzb₄ in Formula (Z-4) each independently represent a hydrogen atom, an alkyl group, or an aryl group, and it is preferable that one of them represents an aryl group.

X in Formula (Z-4) is preferably O, and Y₁ and Y₂ are preferably CH.

The alkyl group in Formula (Z-4) may be linear or branched or may have a ring structure.

The number of carbon atoms in the alkyl group in Formula (Z-4) is preferably 1 to 20, more preferably 1 to 8, and still more preferably 1 to 5.

The number of carbon atoms in the aryl group in Formula (Z-4) is preferably 6 to 20, more preferably 6 to 10, and particularly preferably 6 to 8.

Each of the groups such as the alkyl group and the aryl group in Formula (Z-4) may have a substituent. Examples of the substituent include an alkyl group, an aryl group, a halogen atom, an amino group, an alkylamino group, an arylamino group, a dialkylamino group, a monoalkyl monoarylamino group, a diarylamino group, a hydroxy group, an alkoxy group, an aryloxy group, an acyl group, an alkoxycarbonyl group, an aryloxycarbonyl group, a cyano group, and the like. In addition, these substituents may be further substituted with these substituents.

Examples of the leuco colorant having the phthalide structure or the fluoran structure that are suitably used include the following compounds. Me represents a methyl group.

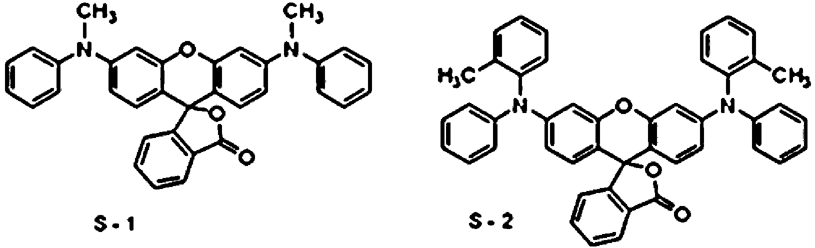

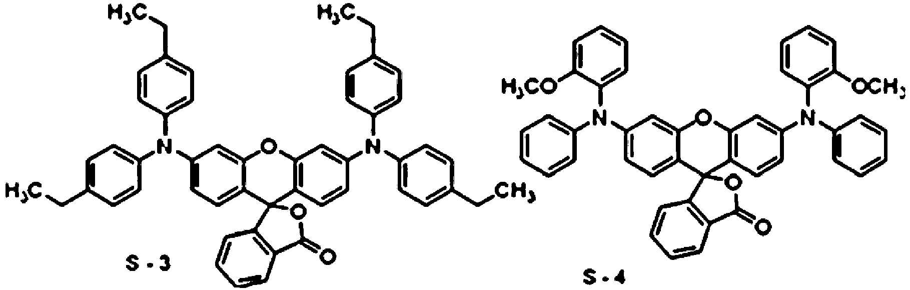

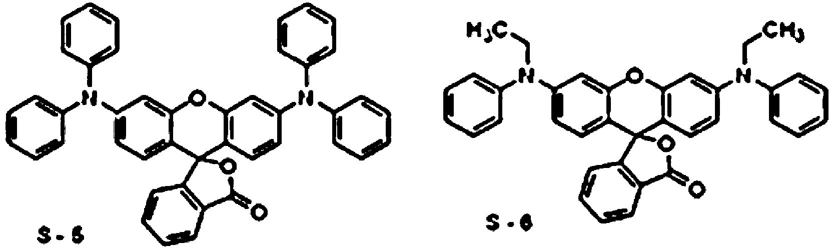

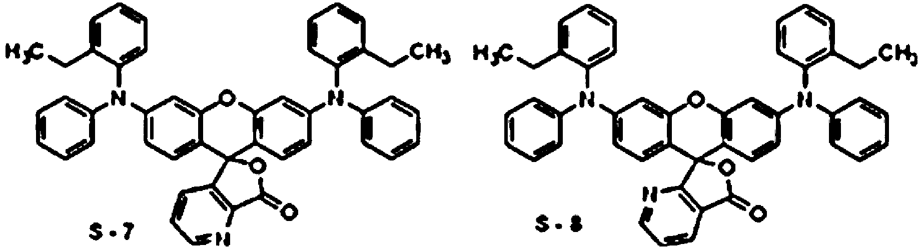

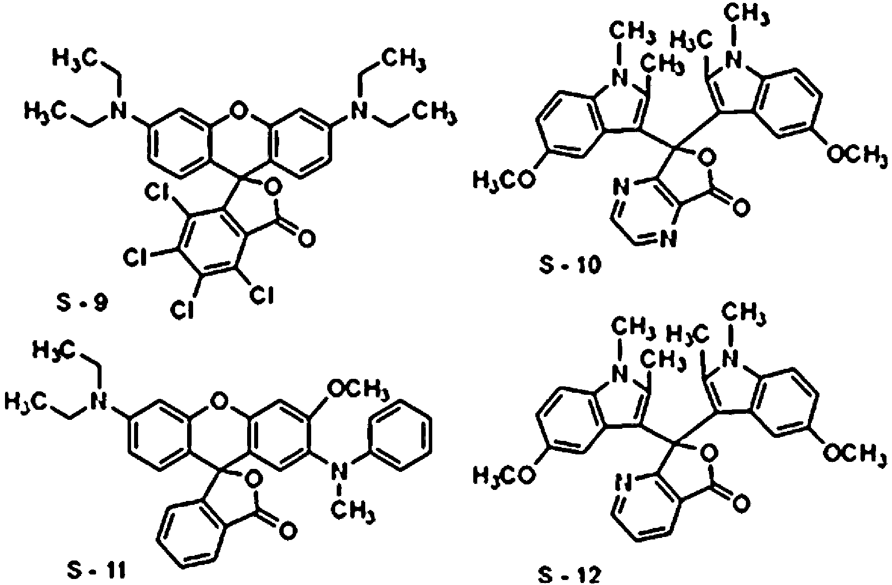

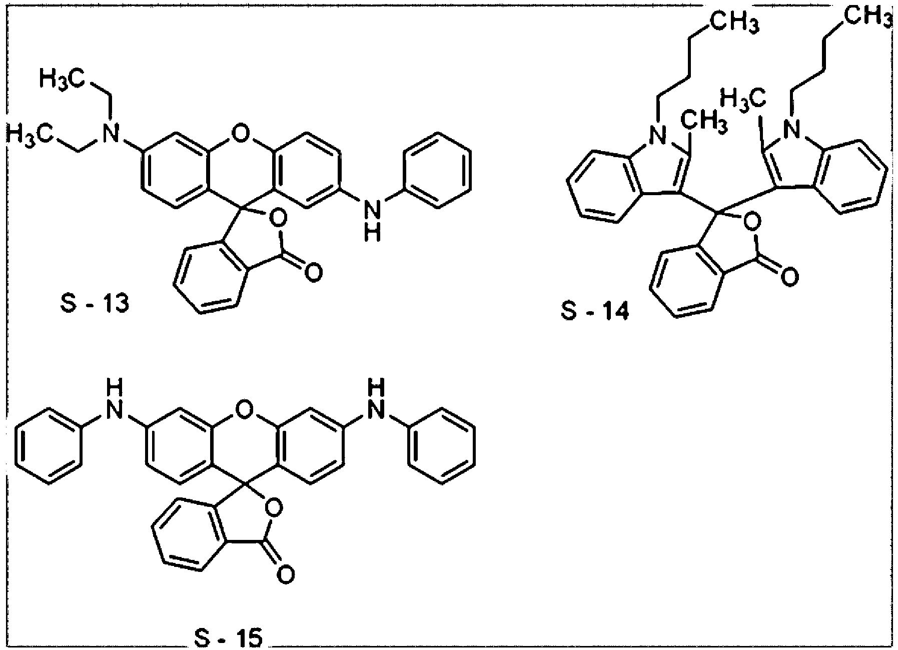

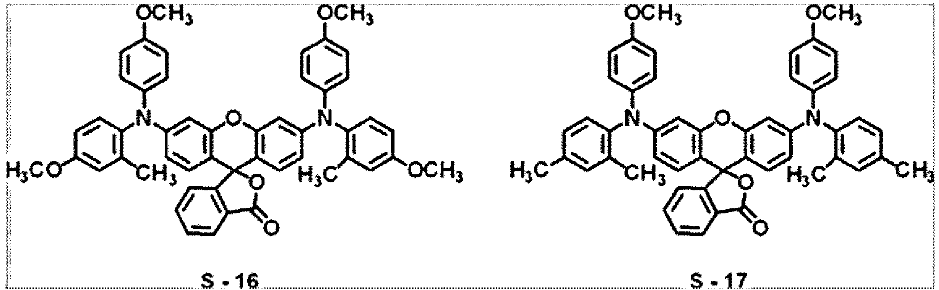

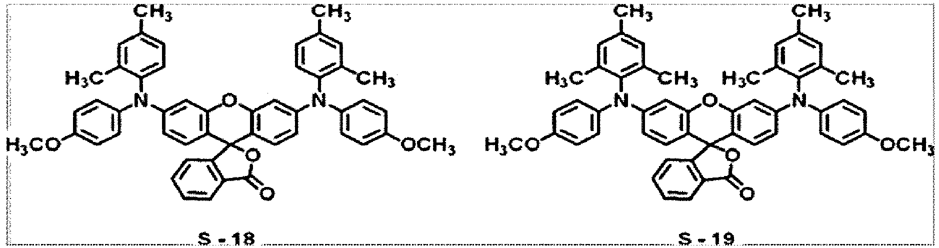

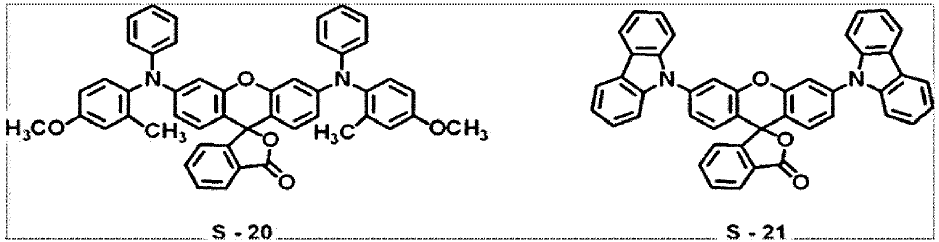

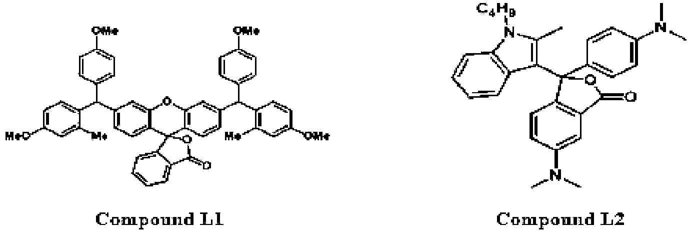

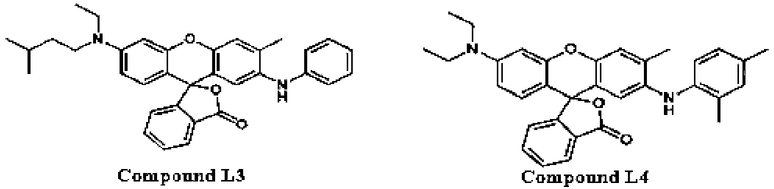

As the color developing agent, commercially available products can be used. Examples thereof include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by Hodogaya Chemical Co., Ltd.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals, Inc.), crystal violet lactone (manufactured by Tokyo Chemical Industry Co., Ltd.), and the like.

Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and Crystal Violet Lactone are preferable from the viewpoint that the visible light absorbance of a film to be formed is satisfactory.

These color developing agents may be used alone or in combination of two or more kinds of components.

The content of the color developing agent with respect to the total mass of the image recording layer is preferably 0.5% by mass to 10% by mass, and more preferably 1% by mass to 5% by mass.

### [Binder polymer]

The image recording layer may contain a binder polymer. As the binder polymer, binder polymers that can be used in an image recording layer of on-press development type lithographic printing plate precursors can be used. Specifically, as the binder polymer, the binder polymer described in paragraphs "0288" to "0317" of WO2022/019217A can be suitably used.

In the image recording layer used in the present disclosure, one binder polymer may be used alone, or two or more binder polymers may be used in combination.

The content of the binder polymer to be contained in the image recording layer can be optionally set, and the content of the binder polymer with respect to the total mass of the image recording layer is preferably 1% by mass to 90% by mass and more preferably 5% by mass to 80% by mass.

In a case where the image recording layer of the present disclosure contains other binder polymers, the content of those other binder polymers with respect to the total mass of the aforementioned thermoplastic resin particles and those other binder polymers is preferably more than 0% by mass and 99% by mass or less, more preferably 20% by mass to 95% by mass, and even more preferably 40% by mass to 90% by mass.

### [Oil agent]

The image recording layer may further contain an oil agent.

In the present disclosure, an oil agent refers to a hydrophobic compound that is in a liquid state at 80°C and is not mixed with water and separates in a case where the compound is mixed with water of the same mass.

In a case where two or more oil agents are used, the oil agents may include a compound having a melting point of 80°C or higher as long as the two or more oil agents are in a liquid state at 80°C in a mixed state.

In addition, from the viewpoint of on-press developability and dampening water turbidity suppressiveness, the oil agent is preferably a compound having a molecular weight less than 1,000, more preferably a compound having a molecular weight of 200 to 800, and particularly preferably a compound having a molecular weight of 300 to 500.

Furthermore, from the viewpoint of on-press developability and dampening water turbidity suppressiveness, the oil agent is preferably a compound having a boiling point of 200°C or higher at 1 atm, more preferably a compound having a boiling point of 250°C or higher at 1 atm, even more preferably a compound having a boiling point of 300°C or higher at 1 atm, and particularly preferably a compound having a boiling point of 400°C or higher and 500°C or lower at 1 atm.

In the present disclosure, unless otherwise specified, "boiling point" means a boiling point at 1 atm.

In addition, from the viewpoint of on-press developability and dampening water turbidity suppressiveness, the melting point of the oil agent at 1 atm is preferably 50°C or lower, more preferably 30°C or lower, and particularly preferably -200°C or higher and 25°C or lower.

In the present disclosure, unless otherwise specified, "melting point" means a melting point at 1 atm.

Examples of the oil agent include a phosphoric acid ester compound, an aromatic hydrocarbon compound, a glyceride compound, a fatty acid compound, an aromatic ester compound, and the like.

Among the above, from the viewpoint of UV printing durability, receptivity, on-press developability, and dampening water turbidity suppressiveness, at least one compound selected from the group consisting of a phosphoric acid ester compound, an aromatic hydrocarbon compound, a glyceride compound, and an aromatic ester compound is preferable, at least one compound selected from the group consisting of a phosphoric acid ester compound, an aromatic hydrocarbon compound, and a glyceride compound is more preferable, at least one compound selected from the group consisting of a phosphoric acid ester compound and an aromatic hydrocarbon compound is even more preferable, and a phosphoric acid ester compound is particularly preferable.

As the phosphoric acid ester compound, from the viewpoints of UV printing durability, receptivity, on-press developability, and dampening water turbidity suppressiveness, a phosphoric acid triester compound is preferable, a phosphoric acid triaryl ester compound is more preferable, tricresyl phosphate is even more preferable, and a mixture of two or more isomers among ortho, meta, and para isomers of tricresyl phosphate is particularly preferable.

As the aromatic hydrocarbon compound, from the viewpoint of on-press developability and dampening water turbidity suppressiveness, a compound having two or more aromatic rings is preferable, and a compound having two or more unfused benzene rings is more preferable.

As the glyceride compound, from the viewpoint of on-press developability and dampening water turbidity suppressiveness, a triglyceride compound is preferable, a fatty oil is more preferable, and a fatty oil which is a liquid at 25°C, such as castor oil, is particularly preferable.

As the fatty acid compound, from the viewpoint of on-press developability and dampening water turbidity suppressiveness, an unsaturated fatty acid is preferable, an unsaturated fatty acid having a carbon number of 8 to 30 is more preferable, and an unsaturated fatty acid having a carbon number of 12 to 24 is particularly preferable.

As the aromatic ester compound, from the viewpoint of on-press developability and dampening water turbidity suppressiveness, an aromatic diester compound is preferable, and an aromatic diester compound having an aliphatic ring is more preferable.

As the aliphatic ester compound, from the viewpoint of on-press developability and dampening water turbidity suppressiveness, an aliphatic ester compound having a branched alkyl group is preferable, and an aliphatic ester compound having a branched alkyl group and a carbon number of 10 to 24 is more preferable.

From the viewpoints of UV printing durability, receptivity, on-press developability, and dampening water turbidity suppressiveness, the oil agent preferably includes an oil agent having a phosphorus atom, and is more preferably an oil agent having a phosphorus atom.

In addition, from the viewpoint of on-press developability and dampening water turbidity suppressiveness, the oil agent preferably includes an oil agent having an aromatic ring, more preferably includes an oil agent having two or more aromatic rings, and particularly preferably includes an oil agent having two or more unfused benzene rings.

From the viewpoints of UV printing durability, receptivity, on-press developability, and dampening water turbidity suppressiveness, a ClogP value of the oil agent is preferably 5.0 or more, more preferably 5.50 or more, even more preferably 5.50 or more and 10.0 or less, and particularly preferably 5.60 or more and 7.00 or less.

The clogP value is a value obtained by calculating a common logarithm logP of a partition coefficient P of 1-octanol and water. As a method or software used for calculating the clogP value, a known method or software can be used, but in the present disclosure, a ClogP program incorporated in ChemBioDraw Ultra 12.0 of Cambridge Soft is used unless otherwise specified.

Specific examples of the oil agent include tricresyl phosphate, dimethyl(1-phenylethyl) benzene, 2,4-diphenyl-4-methyl-1-pentene, dicyclohexylphthalate, castor oil, α-linolenic acid, tri(2-ethylhexyl) phosphate, and the like.

One oil agent may be used alone, or two or more oil agents may be used in combination. From the viewpoint of on-press developability and dampening water turbidity suppressiveness, it is preferable that the image recording layer contain two or more oil agents having different structures.

The content of the oil agent with respect to the total mass of the image recording layer is preferably 0.0001% by mass to 10.0% by mass, more preferably 0.0002% by mass to 1.0% by mass, even more preferably 0.0005% by mass to 0.5% by mass, and particularly preferably 0.001% by mass to 0.05% by mass.

### [Chain transfer agent]

The image recording layer may contain a chain transfer agent. As the chain transfer agent, a chain transfer agent used for an image recording layer of an on-press development type lithographic printing plate precursor can be used. Specifically, as the chain transfer agent, the chain transfer agents described in paragraphs "0388" to "0393" of WO2022/019217A can be suitably used.

Only one chain transfer agent may be added to the image recording layer, or two or more chain transfer agents may be used in combination.

The content of the chain transfer agent with respect to the total mass of the image recording layer is preferably 0.01% by mass to 50% by mass, more preferably 0.05% by mass to 40% by mass, and still more preferably 0.1% by mass to 30% by mass.

### [Oil sensitizing agent]

In order to improve the ink receptivity, the image recording layer may contain an oil sensitizing agent. As the oil sensitizing agent, an oil sensitizing agent used for an image recording layer of an on-press development type lithographic printing plate precursor can be used. Specifically, as the oil sensitizing agent, the oil sensitizing agents described in paragraphs "0395" to "0404" of WO2022/019217A can be suitably used.

The content of the oil sensitizing agent with respect to the total mass of the image recording layer is preferably 1% by mass to 40.0% by mass, more preferably 2% by mass to 25.0% by mass, and even more preferably 3% by mass to 20.0% by mass.

The image recording layer may contain only one oil sensitizing agent, or two or more oil sensitizing agents may be used in combination.

One of the preferred aspects of the image recording layer used in the present disclosure is an aspect in which the image recording layer contains two or more types of compounds as an oil sensitizing agent.

Specifically, from the viewpoint of satisfying both the on-press developability and receptivity, the image recording layer used in the present disclosure preferably uses all the phosphonium compound, the nitrogen-containing low-molecular-weight compound, and the ammonium group-containing polymer as an oil sensitizing agent, and more preferably uses all the phosphonium compound, the quaternary ammonium salts, and the ammonium group-containing polymer as an oil sensitizing agent.

### [Development accelerator]

The image recording layer preferably further contains a development promoting agent.

The value of polarity element as an SP value of the development accelerator is preferably 6.0 to 26.0, more preferably 6.2 to 24.0, even more preferably 6.3 to 23.5, and particularly preferably 6.4 to 22.0.

In the present disclosure, as the value of polarity element as an SP value (solubility parameter, unit: (cal/cm³)^{1/2}), the value of polarity element δp in the Hansen solubility parameters is used. The Hansen solubility parameter is obtained by dividing a solubility parameter introduced by Hildebrand into three components of a dispersion element δd, a polarity element δp, and a hydrogen bond element δh, and representing the three components in a three-dimensional space.

In the present disclosure, the polarity element δp is used.

δp[cal/cm³] is a dipole-dipole force element in the Hansen solubility parameter, V[cal/cm³] is a molar volume, and µ[D] is a dipole moment. As δp, the following expression simplified by Hansen and Beerbower is generally used.${δ}_{p} = \frac{37.4 μ}{{V}^{1 / 2}}$

The development accelerator is preferably a hydrophilic polymer compound or a hydrophilic low-molecular-weight compound.

In the present disclosure, "hydrophilic" means that the value of polarity element as an SP value is 6.0 to 26.0, the hydrophilic polymer compound refers to a compound having a molecular weight (weight-average molecular weight in a case where the compound has molecular weight distribution) of 3,000 or more, and the hydrophilic low-molecular-weight compound refers to a compound having a molecular weight (weight-average molecular weight in a case where the compound has molecular weight distribution) of less than 3,000.

Examples of the hydrophilic polymer compound include a cellulose compound and the like. Among these, a cellulose compound is preferable.

Examples of the cellulose compound include cellulose or a compound obtained by modifying at least a part of cellulose (modified cellulose compound). Among these, a modified cellulose compound is preferable.

Preferred examples of the modified cellulose compound include a compound which is obtained by substituting at least some of hydroxy groups of cellulose with at least one type of group selected from the group consisting of an alkyl group and a hydroxyalkyl group.

The degree of substitution of the compound, which is obtained by substituting at least some of hydroxy groups of cellulose with at least one kind of group selected from the group consisting of an alkyl group and a hydroxyalkyl group, is preferably 0.1 to 6.0, and more preferably 1 to 4.

As the modified cellulose compound, an alkyl cellulose compound or a hydroxyalkyl cellulose compound is preferable, and a hydroxyalkyl cellulose compound is more preferable.

Preferred examples of the alkyl cellulose compound include methyl cellulose.

Preferred examples of the hydroxyalkyl cellulose compound include hydroxypropyl cellulose.

The molecular weight of the hydrophilic polymer compound (weight-average molecular weight in a case where the compound has molecular weight distribution) is preferably 3,000 to 5,000,000, and more preferably 5,000 to 200,000.

Examples of the hydrophilic low-molecular-weight compound include a glycol compound, a polyol compound, an organic amine compound, an organic sulfonic acid compound, an organic sulfamine compound, an organic sulfuric acid compound, an organic phosphonic acid compound, an organic carboxylic acid compound, a betaine compound, and the like. Among these, a polyol compound, an organic sulfonic acid compound, or a betaine compound is preferable.

Examples of the glycol compound include glycols such as ethylene glycol, diethylene glycol, triethylene glycol, propylene glycol, dipropylene glycol, and tripropylene glycol, and ether or ester derivatives of these compounds.

Examples of the polyol compound include glycerin, pentaerythritol, tris(2-hydroxyethyl) isocyanurate, and the like.

Examples of the organic amine compound include triethanolamine, diethanolamine, monoethanolamine, salts of these, and the like.

Examples of the organic sulfonic acid compound include alkyl sulfonic acid, toluene sulfonic acid, benzene sulfonic acid, salts of these, and the like. Among these, for example, alkyl sulfonic acid having an alkyl group having 1 to 10 carbon atoms is preferable.

Examples of the organic sulfamine compound include alkylsulfamic acid, salts thereof, and the like.

Examples of the organic sulfuric acid compound include alkyl sulfate, alkyl ether sulfuric acid, salts of these, and the like.

Examples of the organic phosphonic acid compound include phenylphosphonic acid, salts thereof, and the like.

Examples of the organic carboxylic acid compound include tartaric acid, oxalic acid, citric acid, malic acid, lactic acid, gluconic acid, salts of these, and the like.

Examples of the betaine compound include a phosphobetaine compound, a sulfobetaine compound, a carboxybetaine compound, and the like. Among these, for example, trimethylglycine is preferable.

The molecular weight of the hydrophilic low-molecular-weight compound (weight-average molecular weight in a case where the compound has molecular weight distribution) is preferably 100 or more and less than 3,000, and more preferably 300 to 2,500.

The development accelerator is preferably a compound having a cyclic structure.

The cyclic structure is not particularly limited. Examples thereof include a glucose ring in which at least some of hydroxy groups may be substituted, an isocyanuric ring, an aromatic ring which may have a heteroatom, an aliphatic ring which may have a heteroatom, and the like. Among these, for example, a glucose ring or an isocyanuric ring is preferable.

Examples of the compound having a glucose ring include the aforementioned cellulose compound.

Examples of the compound having an isocyanuric ring include the aforementioned tris(2-hydroxyethyl) isocyanurate and the like.

Examples of the compound having an aromatic ring include the toluene sulfonic acid and benzene sulfonic acid described above, and the like.

Examples of the compound having an aliphatic ring include a compound which is the aforementioned alkyl sulfate and has an alkyl group having a ring structure, and the like.

The compound having a cyclic structure preferably has a hydroxy group.

Preferred examples of the compound having a hydroxy group and a cyclic structure include the aforementioned cellulose compound and the aforementioned tris(2-hydroxyethyl) isocyanurate.

The development accelerator is preferably an onium salt compound.

Examples of the onium salt compound include an ammonium compound, a sulfonium compound, and the like. Among these, an ammonium compound is preferable.

Examples of the development accelerator which is an onium salt compound include trimethylglycine and the like.

The value of polarity element as an SP value of the onium salt compound in the electron-accepting polymerization initiator is not in a range of 6.0 to 26.0. This onium salt compound is not included in the development accelerator.

The image recording layer may contain only one type of development accelerator, or two or more types of development accelerators may be used in combination.

In the present disclosure, one of the preferred aspects of the image recording layer is an aspect in which two or more kinds of compounds are contained as the development promoting agent.

Specifically, from the viewpoint of on-press developability and ink receptivity, the image recording layer preferably contains the above-described polyol compound and the above-described betaine compound, the above-described betaine compound and the above-described organic sulfonic acid compound, or the above-described polyol compound and the above-described organic sulfonic acid compound as the development promoting agent.

The content of the development accelerator with respect to the total mass of the image recording layer is preferably 0.1% by mass or more and 20% by mass or less, more preferably 0.5% by mass or more and 15% by mass or less, and even more preferably 1% by mass or more and 10% by mass or less.

### [Other components]

As other components, a surfactant, a polymerization inhibitor, a higher fatty acid derivative, a plasticizer, inorganic particles, an inorganic lamellar compound, and the like can be incorporated into the image recording layer. Specifically, the description in paragraphs "0114" to "0159" of JP2008-284817A can be referred to.

### <<Formation of image recording layer>>

The image recording layer in the lithographic printing plate precursor according to the present disclosure can be formed, for example, by preparing a coating liquid by dispersing or dissolving the necessary components described above in a known solvent, coating a support with the coating liquid by a known method such as bar coating, and drying the coating liquid, as described in paragraphs "0142" and "0143" of JP2008-195018A. The coating amount (solid content) of the image recording layer after coating and drying varies with uses, but is preferably 0.3 g/m² to 3.0 g/m². In a case where the coating amount is in this range, excellent sensitivity and excellent film forming characteristics of the image recording layer are obtained.

As the solvent, known solvents can be used. Specific examples thereof include water, acetone, methyl ethyl ketone (2-butanone), cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 1-methoxy-2-propanol, 3-methoxy-1-propanol, methoxy methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, ethyl lactate, and the like. One solvent may be used alone, or two or more solvents may be used in combination. The concentration of solid contents in the coating liquid is preferably 1% by mass to 50% by mass.

The coating amount (solid content) of the image recording layer after coating and drying varies with uses. However, from the viewpoint of obtaining excellent sensitivity and excellent film characteristics of the image recording layer, the coating amount is preferably 0.3 g/m² to 3.0 g/m².

The film thickness of the image recording layer in the lithographic printing plate precursor according to the present disclosure is preferably 0.1 µm to 3.0 µm, and more preferably 0.3 µm to 2.0 µm.

In the present disclosure, the film thickness of each layer in the lithographic printing plate precursor is checked by preparing a slice by cutting the lithographic printing plate precursor in a direction perpendicular to the surface of the precursor and observing the cross section of the slice with a scanning electron microscope (SEM).

### (Support)

The lithographic printing plate precursor according to the present disclosure has a support.

The support to be used can be appropriately selected from known supports for a lithographic printing plate precursor.

As the support, a support having a hydrophilic surface (hereinafter, also called "hydrophilic support") is preferable.

As the support in the present disclosure, an oxide film is preferably provided, and an aluminum plate which has been subjected to a roughening treatment and an anodization treatment by a known method is more preferable. That is, the support in the present disclosure preferably has an aluminum plate and an anodic oxide film of aluminum disposed on the aluminum plate.

In addition, it is preferable that the support has an aluminum plate and an anodic oxide film of aluminum disposed on the aluminum plate, the anodic oxide film is at a position closer to a side of the image recording layer than the aluminum plate and has micropores extending in a depth direction from the surface of the anodic oxide film on the side of the image recording layer, and the average diameter of the micropores within the surface of the anodic oxide film is more than 10 nm and 100 nm or less.

Furthermore, the micropores are preferably each composed of a large diameter portion that extends to a position at a depth of 10 nm to 1,000 nm from the surface of the anodic oxide film and a small diameter portion that is in communication with a bottom portion of the large diameter portion and extends to a position at a depth of 20 nm to 2,000 nm from a communicate position, an average diameter of the large diameter portion within the surface of the anodic oxide film is preferably 15 nm to 100 nm, and an average diameter of the small diameter portion at the communication position is preferably 13 nm or less.

In addition, it is preferable that the support has an oxide film on a surface of the support, the oxide film has micropores extending from the surface of the oxide film on the image recording layer side in the depth direction, and the micropores have large-diameter hole portions in which an average pore diameter of the surface of the oxide film is 15 nm to 100 nm and small-diameter hole portions which communicate with bottom portions of the large-diameter hole portions and further extend from the communicating position in the depth direction, and an average pore diameter of the small-diameter hole portions is 15 nm or less.

Further, it is preferable that the support has an oxide film on a surface of the support, the oxide film has micropores extending from the surface of the oxide film on the image recording layer side in the depth direction, and a maximum diameter of the micropores inside the micropores is 1.2 times to 10 times an average pore diameter of the surface of the oxide film.

FIG. 1 is a schematic cross-sectional view of an embodiment of an aluminum support 12a.

The aluminum support 12a has a laminated structure in which an aluminum plate 18 and an anodic oxide film 20a of aluminum (hereinafter, also simply called "anodic oxide film 20a") are laminated in this order. The anodic oxide film 20a in the aluminum support 12a is positioned such that the anodic oxide film 20a is closer to the image recording layer side than the aluminum plate 18. That is, it is preferable that the lithographic printing plate precursor according to the present disclosure have at least an anodic oxide film, an image recording layer, and a water-soluble resin layer in this order on an aluminum plate.

### -Anodic oxide film-

Hereinafter, preferred aspects of the anodic oxide coating film 20a will be described.

The anodic oxide film 20a is a film prepared on a surface of the aluminum plate 18 by an anodization treatment. This film has uniformly distributed ultrafine micropores 22a approximately perpendicular to the surface of the film. The micropores 22a extend from a surface of the anodic oxide film 20a on the image recording layer side (a surface of the anodic oxide film 20a opposite to the aluminum plate 18 side) along the thickness direction (toward the aluminum plate 18 side).

The average diameter (average opening diameter) of the micropores 22a on the surface of the anodic oxide film 20a is preferably more than 10 nm and 100 nm or less. Particularly, from the viewpoint of balance between printing durability, antifouling properties, and image visibility, the average diameter of the micropores 22a is more preferably 15 nm to 60 nm, even more preferably 20 nm to 50 nm, and particularly preferably 25 nm to 40 nm. The internal diameter of the pores may be larger or smaller than the pore diameter within the surface layer.

In a case where the average diameter is more than 10 nm, printing durability and image visibility are excellent. Furthermore, in a case where the average diameter is 100 nm or less, printing durability is excellent.

The average diameter of the micropores 22a is a value determined by observing the surface of the anodic oxide film 20a with a field emission scanning electron microscope (FE-SEM) at 150,000X magnification (N = 4), measuring the size (diameter) of 50 micropores existing in a range of 400 nm × 600 nm in the obtained 4 images, and calculating the arithmetic mean thereof.

In a case where the shape of the micropores 22a is not circular, the equivalent circular diameter is used. The term "equivalent circular diameter" denotes a diameter of a circle obtained by assuming the shape of an opening portion as a circle having the same projected area as the projected area of the opening portion.

The shape of the micropores 22a is not particularly limited. In FIG. 1, the micropores 22a have a substantially straight tubular shape (substantially cylindrical shape). However, the micropores 22a may have a conical shape that tapers along the depth direction (thickness direction). The shape of the bottom portion of the micropores 22a is not particularly limited, and may be a curved (convex) or flat surface shape.

In the support, the micropores may be each composed of a large diameter portion that extends to a position at a certain depth from the surface of the anodic oxide film and a small diameter portion that is in communication with a bottom portion of the large diameter portion and extends to a position at a certain depth from the communicate position.

For example, as shown in FIG. 2, an aspect may be adopted in which an aluminum support 12b includes an aluminum plate 18 and an anodic oxide film 20b having micropores 22b each composed of a large diameter portion 24 and a small diameter portion 26.

For example, the micropores 22b in the anodic oxide film 20b may be composed of a large-diameter hole portion 24 extending from the surface of the anodic oxide film to a position at a depth of 10 nm to 1,000 nm (depth D: see FIG. 2) and a small-diameter hole portion 26 communicating with the bottom portion of the large-diameter hole portion 24 and extending from the communication position to a position at a depth of 20 nm to 2,000 nm.

The micropores 22b are composed of the small-diameter hole portion 26. Specifically, for example, it is possible to use the aspect described in paragraphs "0107" to "0114" of JP2019-162855A.

### -Manufacturing method of support-

As a manufacturing method of the support used in the present disclosure, for example, a manufacturing method is preferable in which the following steps are sequentially performed.
· Roughening treatment step: step of performing roughening treatment on aluminum plate
· Anodization treatment step: step of subjecting aluminum plate having undergone roughening treatment to anodization
· Pore widening treatment step: step of bringing aluminum plate having anodic oxide film obtained by anodization treatment step into contact with aqueous acid solution or aqueous alkali solution such that diameter of micropores in anodic oxide film increases

Hereinafter, the procedures of each step will be described in detail.

### <<Roughening treatment step>>

The roughening treatment step is a step of performing a roughening treatment including an electrochemical roughening treatment on the surface of the aluminum plate. This step is preferably performed before the anodization treatment step which will be described later. However, in a case where the surface of the aluminum plate already has a preferable shape, the roughening treatment step may not be performed. This step can be carried out by the method described in paragraphs "0086" to "0101" of JP2019-162855A.

### <<Anodization treatment step>>

The procedure of the anodization treatment step is not particularly limited as long as the aforementioned micropores can be obtained. Examples thereof include known methods.

In the anodization treatment step, an aqueous solution of sulfuric acid, phosphoric acid, oxalic acid, and the like can be used as an electrolytic bath. For example, the concentration of sulfuric acid is 100 g/L to 300 g/L.

The conditions of the anodization treatment are appropriately set depending on the electrolytic solution used. For example, the liquid temperature is 5°C to 70°C (preferably 10°C to 60°C), the current density is 0.5 A/dm² to 60 A/dm² (preferably 1 A/dm² to 60 A/dm²), the voltage is 1 V to 100 V (preferably 5 V to 50 V), the electrolysis time is 1 second to 100 seconds (preferably 5 seconds to 60 seconds), and the film amount is 0.1 g/m² to 5 g/m² (preferably 0.2 g/m² to 3 g/m²).

### Pore widening treatment

The pore widening treatment is a treatment of enlarging the diameter of micropores (pore diameter) present in the anodic oxide film formed by the aforementioned anodization treatment step (pore diameter enlarging treatment).

The pore widening treatment can be carried out by bringing the aluminum plate obtained by the anodization treatment step into contact with an aqueous acid solution or an aqueous alkali solution. The method of bringing the aluminum support into contact with the solution is not particularly limited, and examples thereof include an immersion method and a spray method.

As necessary, the support may have a backcoat layer on the side opposite to the image recording layer, the backcoat layer containing the organic polymer compound described in JP1993-45885A (JP-H5-45885A) or the alkoxy compound of silicon described in JP1994-35174A (JP-H6-35174A).

### (Undercoat layer (interlayer))

The lithographic printing plate precursor according to the present disclosure preferably has an undercoat layer (also called interlayer in some cases) between the image recording layer and the support. The undercoat layer enhances the adhesiveness between the support and the image recording layer in an exposed portion, and enables the image recording layer to be easily peeled from the support in a non-exposed portion. Therefore, the undercoat layer inhibits the deterioration of printing durability and contributes to the improvement of developability. Furthermore, in the case of exposure to infrared laser, the undercoat layer functions as a heat insulating layer and thus brings about an effect of preventing sensitivity reduction resulting from the diffusion of heat generated by exposure to the support.

Examples of the compound used for the undercoat layer include a polymer having an adsorptive group (support adsorptive group) capable of being adsorbed on the surface of the support and a hydrophilic group. In order to improve adhesiveness to the image recording layer, polymers having adsorbent groups and hydrophilic groups plus crosslinking groups are preferable. The compounds that are used in the undercoat layer may be low-molecular-weight compounds or polymers. As necessary, as the compounds that are used in the undercoat layer, two or more kinds of compounds may be used by being mixed together.

In a case where the compound used in the undercoat layer is a polymer, a copolymer of a monomer having an adsorbent group, a monomer having a hydrophilic group, and a monomer having a crosslinking group is preferable.

As the adsorbent group that can be adsorbed onto the surface of the support, a phenolic hydroxyl group, a carboxy group, -PO₃H₂, -OPO₃H₂, -CONHSO₂-, -SO₂NHSO₂-, and - COCH₂COCH₃ are preferable. As the hydrophilic groups, a sulfo group or salts thereof and salts of a carboxy group are preferable. As the crosslinkable groups, an acryloyl group, a methacryloyl group, an acrylamide group, a methacrylamide group, an allyl group, and the like are preferable.

The polymer may have a crosslinkable group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.

Specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or polymer compounds having crosslinking groups (preferably ethylenically unsaturated bonding groups), functional groups that interact with the surface of the support, and hydrophilic groups described in JP2005-238816A, JP2005-125749A, JP2006-239867A, and JP2006-215263A are also preferably used.

For example, the high-molecular-weight polymers having absorptive groups that can be adsorbed onto the surface of the support, hydrophilic groups, and crosslinkable groups described in JP2005-125749A and JP2006-188038A are more preferable.

The content of ethylenically unsaturated bonding group in the polymer used in the undercoat layer is preferably 0.1 mmol to 10.0 mmol per gram of the polymer, and more preferably 0.2 mmol to 5.5 mmol per gram of the polymer.

The weight-average molecular weight (Mw) of the polymer used in the undercoat layer is preferably 5,000 or more and more preferably 10,000 to 300,000.

In order to prevent contamination with the passage of time, the undercoat layer may contain, in addition to the compounds for the undercoat layer described above, a chelating agent, a secondary or tertiary amine, a polymerization inhibitor, a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, hydroxyethyl ethylenediaminetriacetic acid, dihydroxyethyl ethylenediaminediacetic acid, hydroxyethyl iminodiacetic acid, and the like), and the like.

Among these, from the viewpoint of printing durability and on-press developability, it is preferable that the lithographic printing plate precursor according to the present disclosure further includes an interlayer between the support and the image recording layer, and the interlayer contains a copolymer having a support absorptive group and a hydrophilic group.

The undercoat layer is formed by known coating methods. The coating amount (solid content) of the undercoat layer is preferably 0.1 mg/m² to 100 mg/m² and more preferably 1 mg/m² to 30 mg/m².

### <Overcoat layer>

It is preferable that the planographic printing plate precursor according to the embodiment of the present disclosure has a overcoat layer (also referred to as a protective layer) on a surface of the image recording layer opposite to the side of the support.

In addition, it is preferable that the lithographic printing plate precursor according to the present disclosure includes a support, an image recording layer, and an overcoat layer in this order.

The overcoat layer has a function of suppressing an image formation-impairing reaction caused by oxygen shielding and may additionally have a function of preventing the generation of scratches in the image recording layer and the ablation during exposure using high-illuminance lasers.

Such an overcoat layer having the above-described characteristics is described in US3458311A and JP1980-049729B (JP-S55-049729B). As a polymer with low oxygen permeability which is used for the overcoat layer, any of a water-soluble polymer or a water-insoluble polymer can be appropriately selected and used, and two or more kinds thereof can be mixed and used as necessary. Further, from the viewpoint of the on-press developability, it is preferable that the overcoat layer contains a water-soluble polymer.

In the present disclosure, a water-soluble polymer means a polymer having a solubility of more than 5% by mass in water at 25°C.

Examples of the water-soluble polymer used in the overcoat layer include polyvinyl alcohol, modified polyvinyl alcohol, polyvinylpyrrolidone, a cellulose derivative, polyethylene glycol, poly(meth)acrylonitrile, and the like.

Furthermore, the hydrophilic polymer preferably includes at least one compound selected from the group consisting of a modified polyvinyl alcohol and a cellulose derivative.

As the modified polyvinyl alcohol, an acid-modified polyvinyl alcohol having a carboxy group or a sulfo group is preferably used. Specific examples thereof include modified polyvinyl alcohols described in JP2005-250216A and JP2006-259137A.

Examples of the cellulose derivative include methyl cellulose, hydroxypropyl methyl cellulose, and carboxymethyl cellulose.

Among the above water-soluble polymers to be incorporated into the outermost layer, polyvinyl alcohol is preferable, and polyvinyl alcohol having a saponification degree of 50% or more is more preferable.

The saponification degree is preferably 60% or more, more preferably 70% or more, and even more preferably 85% or more. The upper limit thereof of the saponification degree is not particularly limited, and may be 100% or less.

The saponification degree is measured according to the method described in JIS K 6726: 1994.

Further, as an embodiment of the overcoat layer, an embodiment in which the overcoat layer contains polyvinyl alcohol and polyethylene glycol is also preferable.

In a case where the overcoat layer of the present disclosure contains a water-soluble polymer, the content of the water-soluble polymer is preferably in a range of 1% by mass to 99% by mass, more preferably in a range of 3% by mass to 97% by mass, and still more preferably in a range of 5% by mass to 95% by mass with respect to the total mass of the overcoat layer.

The overcoat layer preferably contains a hydrophobic polymer.

The hydrophobic polymer refers to a polymer which is dissolved less than 5 g or is not dissolved in 100 g of pure water at 125°C.

Examples of the hydrophobic polymer include polyethylene, polystyrene, polyvinyl chloride, polyvinylidene chloride, polyalkyl (meth)acrylate ester (for example, polymethyl (meth)acrylate, polyethyl (meth)acrylate, polybutyl (meth)acrylate, and the like), a copolymer obtained by combining raw material monomers of these resins, and the like.

In addition, the hydrophobic polymer preferably includes a polyvinylidene chloride resin.

Furthermore, the hydrophobic polymer preferably includes a styrene-acrylic copolymer (also called styrene acrylic resin).

Furthermore, from the viewpoint of on-press developability, the hydrophobic polymer is preferably hydrophobic polymer particles.

Only one type of hydrophobic polymer may be used, or two or more types of hydrophobic polymers may be used in combination.

In a case where the overcoat layer contains a hydrophobic polymer, the content of the hydrophobic polymer with respect to the total mass of the overcoat layer is preferably 1% by mass to 70% by mass, more preferably 5% by mass to 50% by mass, and even more preferably 10% by mass to 40% by mass.

In the present disclosure, the proportion of the area of the hydrophobic polymer occupying the surface of the overcoat layer is preferably 30 area% or higher, more preferably 40 area% or higher, and even more preferably 50 area% or higher.

The upper limit of the proportion of the area of the hydrophobic polymer occupying the surface of the overcoat layer is, for example, 90 area%.

The proportion of the area of the hydrophobic polymer occupying the surface of the overcoat layer can be measured as follows.

By using PHI nano TOFII time-of-flight secondary ion mass spectrometer (TOF-SIMS) manufactured by ULVAC-PHI, INCORPORATED., the surface of the overcoat layer is irradiated with Bi ion beams (primary ions) at an acceleration voltage of 30 kV, and the peak of ions (secondary ions) corresponding to a hydrophobic portion (that is, a region formed of the hydrophobic polymer) that are emitted from the surface is measured so that the hydrophobic portion is mapped. By measuring the area of the hydrophobic portion in an area of 1 µm², the proportion of the area occupied by the hydrophobic portion is determined and adopted as "proportion of the area of the hydrophobic polymer occupying the surface of the overcoat layer".

For example, in a case where the hydrophobic polymer is an acrylic resin, the proportion is measured using the peak of C₆H₁₃O⁻. In addition, in a case where the hydrophobic polymer is polyvinylidene chloride, the proportion is measured using the peak of C₂H₂Cl⁺.

The proportion of occupied area can be adjusted by the amount of the hydrophobic polymer added or the like.

From the viewpoint of suppressing development defect failure, the overcoat layer preferably contains a filler.

Examples of the filler include inorganic particles, organic resin particles, and an inorganic lamellar compound, and the like. Among these, an inorganic lamellar compound is preferable. By using an inorganic lamellar compound, it is possible to effectively inhibit an attachment re-attached from the roll surface from being directly attached to the surface of the image recording layer.

Examples of the inorganic particles include metal oxide particles such as silica particles.

Examples of the organic resin particles include crosslinked resin particles.

The inorganic lamellar compound refers to particles having thin flat plate shapes, and examples thereof include mica groups such as natural mica and synthetic mica, talc represented by a formula 3MgO·4SiO·H₂O, taeniolite, montmorillonite, saponite, hectorite, and zirconium phosphate.

As the inorganic lamellar compound, a mica compound is preferably used. Examples of the mica compound include a mica compound represented by a formula of A(B,C)₂₋₅D₄O₁₀(OH,F,O)₂[here, A is any of K, Na, and Ca, B and C are any of Fe(II), Fe(III), Mn, Al, Mg, and V, and D is Si or Al. A mica group such as natural mica and synthetic mica represented by the formula is an exemplary example.

In the mica groups, examples of natural mica include white mica, soda mica, gold mica, black mica, and lepidolite. Examples of synthetic mica include non-swelling mica such as fluorophlogopite KMg₃(AlSi₃O₁₀)F₂, potassium tetrasilic mica KMg_{2.5}(Si₄O₁₀)F₂, and, Na tetrasilylic mica NaMg_{2.5}(Si₄O₁₀)F₂, swelling mica such as Na or Li taeniolite (Na, Li)Mg₂Li(Si₄O₁₀)F2, montmorillonite-based Na or Li hectorite (Na, Li)_{1/8}Mg_{2/5}Li_{1/8}(Si₄O₁₀)F₂, and the like. Furthermore, synthetic smectite is also useful.

Among the aforementioned mica compounds, fluorine-based swelling mica is particularly useful. That is, swelling synthetic mica has a laminated structure consisting of unit crystal lattice layers having a thickness in a range of about 10Å to 15Å (1Å is equal to 0.1 nm), and metal atoms in lattices are more actively substituted than in any other clay minerals. As a result, positive charges are deficient in the lattice layers, and positive ions such as Li⁺, Na⁺, Ca²⁺, and Mg²⁺ are absorbed between the layers in order to compensate for the deficiency. Positive ions interposed between the layers are referred to as exchangeable positive ions and are exchangeable with various positive ions. Particularly, in a case where the positive ions between the layers are Li⁺ and Na⁺, the ionic radii are small, and thus the bonds between lamellar crystal lattices are weak, and mica is significantly swollen by water. In a case where shear is applied in this state, mica easily cleavages and forms a stable sol in water. Swelling synthetic mica is particularly preferably used because it clearly exhibits such a tendency.

From the viewpoint of diffusion control, regarding the shapes of the mica compounds, the thickness is preferably thin, and the planar size is preferably large as long as the smoothness and actinic ray-transmitting property of coated surfaces are not impaired. As a result, the aspect ratio is preferably 20 or more, more preferably 100 or more, and particularly preferably 200 or more. The aspect ratio is a ratio of the major axis to the thickness of a particle, and can be measured from projection views obtained from the microphotograph of the particles. The effects to be obtained increase as the aspect ratio increases.

Regarding the particle diameter of the mica compound, the average long diameter thereof is preferably 0.3 µm to 20 µm, more preferably 0.5 µm to 10 µm, and particularly preferably 1 µm to 5 µm. The average thickness of the particles is preferably 0.1 µm or less, more preferably 0.05 µm or less, and particularly preferably 0.01 µm or less. Specifically, for example, as a preferable aspect of swellable synthetic mica which is a representative compound, the thickness thereof is in a range of 1 nm to 50 nm and the surface size (major diameter) is in a range of 1 µm to 20 µm.

The content of the inorganic layered compound is preferably in a range of 1% by mass to 60% by mass and more preferably in a range of 3% by mass to 50% by mass with respect to the total mass of the overcoat layer. Even in a case where a plurality of types of inorganic lamellar compounds are used in combination, the total amount of the inorganic lamellar compounds is preferably the above-described content. In a case where the content is within the above range, the oxygen barrier property is improved, and excellent sensitivity is obtained. In addition, the degradation of receptivity can be prevented.

The overcoat layer may contain known additives such as a plasticizer for imparting flexibility, a surfactant for improving coating properties, and inorganic particles for controlling surface sliding properties. Further, the overcoat layer may contain a sensitizing agent described in the section of the image recording layer.

The overcoat layer is applied by a known method. The coating amount (solid content) of the overcoat layer is preferably in a range of 0.01 g/m² to 10 g/m², more preferably in a range of 0.02 g/m² to 3 g/m², and particularly preferably in a range of 0.02 g/m² to 1 g/m².

The film thickness of the overcoat layer in the planographic printing plate precursor according to the embodiment of the present disclosure is preferably in a range of 0.1 µm to 5.0 µm and more preferably in a range of 0.3 µm to 4.0 µm.

Among these, from the viewpoint of printing durability and developing residue suppressing property, it is preferable that the lithographic printing plate precursor according to the present disclosure further includes an overcoat layer containing an inorganic lamellar compound on the image recording layer.

In addition, from the viewpoint of printing durability and developing residue suppressing property, it is preferable that the lithographic printing plate precursor according to the present disclosure further includes an overcoat layer containing a water-soluble polymer on the image recording layer, and the thickness of the overcoat layer is larger than the thickness of the image recording layer.

The lithographic printing plate precursor according to the present disclosure may have other layers in addition to those described above.

Known layers can be adopted as those other layers without particular limitations. For example, as necessary, a backcoat layer may be provided on a surface of the support that is opposite to the image recording layer side.

### Method of preparing lithographic printing plate and lithographic printing method

It is possible to prepare a lithographic printing plate by performing image exposure and a development treatment on the lithographic printing plate precursor according to the present disclosure.

The method of preparing a lithographic printing plate according to the present disclosure preferably includes a step of exposing the on-press development type lithographic printing plate precursor according to the present disclosure in the shape of an image (hereinafter, this step will be also called "exposure step") and a step of removing the image recording layer in a non-image area by supplying at least one selected from the group consisting of the group consisting of a printing ink and dampening water on a printing press (hereinafter, this step will be also called "on-press development step").

The lithographic printing method according to the present disclosure preferably includes a step of exposing the on-press development type lithographic printing plate precursor according to the present disclosure in the shape of an image (exposure step), a step of removing the image recording layer in a non-image area on a printing press by supplying at least one selected from the group consisting of a printing ink and dampening water such that a lithographic printing plate is prepared (on-press development step), and a step of performing printing by using the obtained lithographic printing plate (printing step).

The method of preparing a lithographic printing plate according to the present disclosure preferably includes a step of exposing an on-press development type lithographic printing plate precursor to an infrared laser in the shape of an image and a step of removing an image recording layer in a non-image area by supplying at least one material selected from the group consisting of printing ink and dampening water on a printer, in which the on-press development type lithographic printing plate precursor preferably has a support and an image recording layer on the support, the image recording layer preferably contains an infrared absorber capable of donating electrons to the aforementioned initiator and a color forming substance precursor, and in a case where the image recording layer is exposed to an infrared laser with a wavelength of 830 nm at an energy density of 110 mJ/cm², a brightness change ΔL of the image recording layer before and after the exposure is preferably 3.0 or more.

Furthermore, the method of preparing a lithographic printing plate according to the present disclosure preferably includes a step of exposing an on-press development type lithographic printing plate precursor to an infrared laser in the shape of an image and a step of removing an image recording layer in a non-image area by supplying at least one material selected from the group consisting of printing ink or dampening water on a printer, in which the on-press development type lithographic printing plate precursor has a support and an image recording layer on the support, the image recording layer preferably contains an initiator, an infrared absorber, and a color forming substance precursor, and the image recording layer preferably satisfies Expression L. $2.0 \leq L 1 - L 0$

In Expression L, L1 represents visibility of the image recording layer, L0 represents the visibility of the image recording layer from which the aforementioned color forming substance precursor has been removed.

Furthermore, regarding the lithographic printing method according to the present disclosure, for example, it is preferable that each of the above aspects include an aspect in which the lithographic printing method further includes the printing step described above.

Hereinafter, regarding the method of preparing a lithographic printing plate according to the present disclosure and the lithographic printing method according to the present disclosure, preferred aspects of each step will be described in order. Note that the lithographic printing plate precursor according to the present disclosure can also be developed using a developer.

Hereinafter, the exposure step and the on-press development step in the method of preparing a lithographic printing plate will be described. The exposure step in the method of preparing a lithographic printing plate according to the present disclosure is the same step as the exposure step in the lithographic printing method according to the present disclosure. Furthermore, the on-press development step in the method of preparing a lithographic printing plate according to the present disclosure is the same step as the on-press development step in the lithographic printing method according to the present disclosure.

### <Exposing step>

The method of preparing a lithographic printing plate according to the present disclosure preferably includes an exposure step of exposing the lithographic printing plate precursor according to the present disclosure in the shape of an image such that an exposed portion and a non-exposed portion are formed. The lithographic printing plate precursor according to the present disclosure is preferably exposed to a laser through a transparent original picture having a linear image, a halftone dot image, or the like or exposed in the shape of an image by laser light scanning according to digital data or the like.

The wavelength of a light source to be used in preferably 750 nm to 1,400 nm. As the light source having a wavelength of 750 nm to 1,400 nm, a solid-state laser or a semiconductor laser that radiates infrared is suitable. In a case where an infrared laser is used, the output is preferably 100 mW or higher, the exposure time per pixel is preferably 20 microseconds or less, and the amount of irradiation energy is preferably 10 mJ/cm² to 300 mJ/cm². For the purpose of reducing the exposure time, it is preferable to use a multi-beam laser device. The exposure mechanism may be any one of an in-plane drum method, an external surface drum method, a flat head method, or the like.

The imagewise exposure can be performed using a plate setter according to a usual method. In the case of on-press development, the image exposure may be carried out on a printer after the lithographic printing plate precursor is mounted on the printer.

### <On-press development step>

The method of preparing a lithographic printing plate according to the present disclosure preferably includes an on-press development step of removing the image recording layer in a non-image area by supplying at least one selected from the group consisting of printing ink and dampening water on a printer.

Hereinafter, the on-press development method will be described.

### [On-press development method]

In the on-press development method, the lithographic printing plate precursor having undergone image exposure is preferably supplied with an oil-based ink and an aqueous component on a printer such that the image recording layer in a non-image area is removed and a lithographic printing plate is prepared.

That is, in a case where the lithographic printing plate precursor is subjected to image exposure and then directly mounted on a printer without being subjected to any development treatment, or in a case where the lithographic printing plate precursor is mounted on a printer, then subjected to image exposure on the printer, and then supplied with an oil-based ink and an aqueous component for printing, at the initial stage in the middle of printing, in a non-image area, a non-cured image recording layer is removed by either or both of the supplied oil-based ink and the aqueous component by means of dissolution or dispersion, and the hydrophilic surface is exposed in the non-image area. Meanwhile, the image recording layer cured by exposure forms an oil-based ink receiving unit having a lipophilic surface in the exposed portion. What is supplied first to the precursor surface may be any of the oil-based ink or the aqueous component. However, in view of preventing the plate from being contaminated by the components of the image recording layer from which aqueous components are removed, it is preferable that the oil-based ink be supplied first. In this manner, the planographic printing plate precursor is subjected to on-press development on the printing press and used for printing multiple sheets. As the oil-based ink and the aqueous component, ordinary printing ink and ordinary dampening water for lithographic printing are suitably used.

As the laser for image-exposing the planographic printing plate precursor according to the embodiment of the present disclosure, a light source having a wavelength of 300 nm to 450 nm or 750 nm to 1400 nm is preferably used. A light source of 300 nm to 450 nm is preferable for a lithographic printing plate precursor including an image recording layer containing sensitizing dye having maximum absorption in such a wavelength range. As the light source of 750 nm to 1,400 nm, those described above are preferably used. As the light source of 300 nm to 450 nm, a semiconductor laser is suitable.

### <Printing step>

The lithographic printing method according to the present disclosure includes a printing step of printing a recording medium by supplying a printing ink to the lithographic printing plate.

The printing ink is not particularly limited, and various known inks can be used as desired.

In addition, preferred examples of the printing ink include oil-based ink or ultraviolet-curable ink (UV ink).

In the printing step, as necessary, dampening water may be supplied.

Furthermore, the printing step may be successively carried out after the on-press development step without stopping the printer.

The recording medium is not particularly limited, and a known recording medium can be used as desired.

In the method of preparing a lithographic printing plate from the lithographic printing plate precursor according to the present disclosure and in the lithographic printing method according to the present disclosure, as necessary, the entire surface of the lithographic printing plate precursor may be heated before exposure, in the middle of exposure, or during a period of time from exposure to development. In a case where the lithographic printing plate precursor is heated as above, an image-forming reaction in the image recording layer is accelerated, which can result in advantages such as improvement of sensitivity and printing durability, stabilization of sensitivity, and the like. Heating before development is preferably carried out under a mild condition of 150°C or lower. In a case where this aspect is adopted, it is possible to prevent problems such as curing of a non-image area. For heating after development, it is preferable to use an extremely severe condition which is preferably in a range of 100°C to 500°C. In a case where the above range is adopted, a sufficient image-strengthening action is obtained, and it is also possible to inhibit issues such as the deterioration of the support or the thermal decomposition of the image area.

### Examples

Hereinafter, the present disclosure will be specifically described based on examples, but the present disclosure is not limited thereto. In the present examples, "%" and "part" respectively indicate "% by mass" and "part by mass" unless otherwise specified. In a polymer compound, the molecular weight indicates the weight-average molecular weight (Mw) and the proportion of structural repeating units indicates mole percentage unless otherwise specified. The weight-average molecular weight (Mw) is a polystyrene-equivalent molecular weight measured by gel permeation chromatography (GPC).

### (Examples 1 to 20 and Comparative Examples 1 and 2)

### <Preparation of support>

### -Preparation of support 1-

The following treatments (F-a) to (F-g) were performed on an aluminum plate (aluminum alloy plate) made of a material 1S having a thickness of 0.3 mm, thereby preparing a support 1. Moreover, during all treatment steps, a water washing treatment was performed, and liquid cutting was performed using a nip roller after the water washing treatment.

### (F-a) Alkali etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. The dissolved aluminum amount of the surface to be subjected to an electrochemical roughening treatment was 5 g/m².

### (F-b) Desmutting treatment using aqueous acidic solution

A desmutting treatment was performed by spraying, as an acidic aqueous solution, an aqueous solution at a solution temperature of 30°C with a sulfuric acid concentration of 150 g/L to the aluminum plate for 3 seconds.

### (F-c) Electrochemical roughening treatment

An electrochemical roughening treatment was performed using the AC current and an electrolyte having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 A/dm² in terms of the peak current value of the alternating current waveform. In addition, the quantity of electricity was 450 C/dm² which was the total quantity of electricity used for the aluminum plate to have an anodic reaction, and the electrolytic treatment was performed 4 times by conducting electricity of 112.5 C/dm² for 4 seconds at each treatment session. A carbon electrode was used as a counter electrode of the aluminum plate.

### (F-d) Alkali etching treatment

An aqueous solution of caustic soda having a caustic soda concentration of 5% by mass and an aluminum ion concentration of 0.5% by mass was sprayed onto the aluminum plate at a temperature of 45°C, thereby performing an etching treatment. The amount of dissolved aluminum within the surface having undergone the electrochemical roughening treatment was 0.2 g/m².

### (F-e) Desmutting treatment using acidic aqueous solution

A desmutting treatment was performed by spraying, as an acidic aqueous solution, an aqueous solution having a sulfuric acid concentration of 170 g/L and an aluminum ion concentration of 5 g/L at a liquid temperature of 35°C, to the aluminum plate using a spray for 3 seconds.

### (F-f) First stage anodization treatment

By using the anodization device for direct current electrolysis having the structure shown in FIG. 3, a first-stage anodization treatment was performed. By using a 150 g/L aqueous phosphoric acid solution as an electrolytic solution, an anodization treatment was performed under the conditions of a liquid temperature of 35°C and a current density of 4.5 A/dm², thereby forming an anodic oxide film having a film amount of 1 g/m².

In the anodization treatment device 610 shown in FIG. 3, an aluminum plate 616 is transported as indicated by the arrow in FIG. 3. In a power supply tank 612 storing an electrolytic solution 618, the aluminum plate 616 is positively (+) charged by a power supply electrode 620. Then, the aluminum plate 616 is transported upwards by a roller 622 in the power supply tank 612, makes a turn downwards by a nip roller 624, then transported toward an electrolytic treatment tank 614 containing an electrolytic solution 626, and makes a turn by a roller 628 to move in the horizontal direction. Subsequently, the aluminum plate 616 is negatively (-) charged by an electrolysis electrode 630. As a result, an anodic oxide film is formed on the surface of the aluminum plate 616. The aluminum plate 616 exits from the electrolytic treatment tank 614 and is then transported for the next step. In the anodization treatment device 610, the roller 622, the nip roller 624, and the roller 628 constitute a direction change unit. Furthermore, in the inter-tank portion between the power supply tank 612 and the electrolytic treatment tank 614, the aluminum plate 616 is transported in a ridge shape and an inverted U shape by the rollers 622, 624, and 628. The power supply electrode 620 and the electrolytic electrode 630 were connected to a DC power source 634.

### (F-g) Second stage anodization treatment

By using the anodization device for direct current electrolysis having the structure shown in FIG. 3, a second-stage anodization treatment was performed. The anodization treatment was performed using a 170 g/L sulfuric acid aqueous solution as an electrolytic solution under conditions of a liquid temperature of 50°C and a current density of 13 A/dm² to form an anodized film having a coating amount of 2.1 g/m². Thereafter, the aluminum plate was washed with water using a spray. The average diameter of the micropores in the support 1 was 40 nm.

The value of the brightness L^{*} of the surface of the anodic oxide film of the support 1 was 83.7 in the L^{*}a^{*}b^{*} color system.

### -Preparation of support (2)-

The following treatments (F-a) to (F-f) were performed on an aluminum plate (aluminum alloy plate) made of a material 1S having a thickness of 0.3 mm, thereby preparing a support 2. Moreover, during all treatment steps, a water washing treatment was performed, and liquid cutting was performed using a nip roller after the water washing treatment.

### (F-a) Alkali etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. The dissolved aluminum amount of the surface to be subjected to an electrochemical roughening treatment was 5 g/m².

### (F-b) Desmutting treatment using aqueous acidic solution

A desmutting treatment was performed by spraying, as an acidic aqueous solution, an aqueous solution at a solution temperature of 30°C with a sulfuric acid concentration of 150 g/L to the aluminum plate for 3 seconds.

### (F-c) Electrochemical roughening treatment

An electrochemical roughening treatment was performed using the AC current and an electrolyte having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 A/dm² in terms of the peak current value of the alternating current waveform. In addition, the quantity of electricity was 450 C/dm² which was the total quantity of electricity used for the aluminum plate to have an anodic reaction, and the electrolytic treatment was performed 4 times by conducting electricity of 112.5 C/dm² for 4 seconds at each treatment session. A carbon electrode was used as a counter electrode of the aluminum plate.

### (F-d) Alkali etching treatment

An aqueous solution of caustic soda having a caustic soda concentration of 5% by mass and an aluminum ion concentration of 0.5% by mass was sprayed onto the aluminum plate at a temperature of 45°C, thereby performing an etching treatment. The amount of dissolved aluminum within the surface having undergone the electrochemical roughening treatment was 0.2 g/m².

### (F-e) Desmutting treatment using acidic aqueous solution

A desmutting treatment was performed by spraying, as an acidic aqueous solution, an aqueous solution having a sulfuric acid concentration of 170 g/L and an aluminum ion concentration of 5 g/L at a liquid temperature of 35°C, to the aluminum plate using a spray for 3 seconds.

### (F-f) First stage anodization treatment

By using the anodization device for direct current electrolysis having the structure shown in FIG. 3, a first-stage anodization treatment was performed. By using a 150 g/L aqueous phosphoric acid solution as an electrolytic solution, an anodization treatment was performed under the conditions of a liquid temperature of 35°C and a current density of 4.5 A/dm², thereby forming an anodic oxide film having a film amount of 1 g/m².

The average diameter of the micropores in the support 2 was 40 nm.

The value of the brightness L* of the surface of the anodic oxide film of the support 2 was 82.4 in the L*a*b* color system.

### -Preparation of support (3)-

A support 3 was produced according to the method for producing a support of Example 5 of WO2021/067054A.

### -Preparation of support (4)-

The following treatments (J-a) to (J-m) were performed on an aluminum plate (aluminum alloy plate) made of a material 1S having a thickness of 0.3 mm, thereby manufacturing a support 4. Moreover, during all treatment steps, a water washing treatment was performed, and liquid cutting was performed using a nip roller after the water washing treatment.

### (J-a) Mechanical roughening treatment (brush grain method)

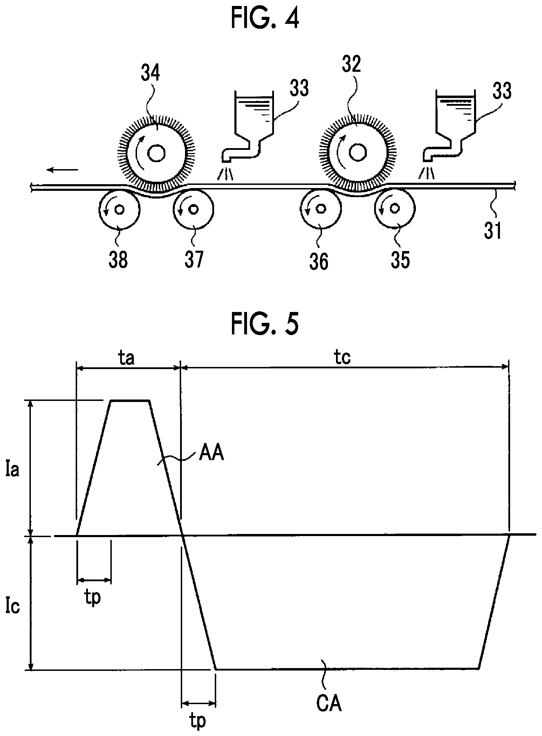

By using the device shown in FIG. 4, a pumice suspension (specific gravity: 1.1 g/cm³) as a polishing slurry liquid was supplied to the surface of an aluminum plate, and in this state, a mechanical roughening treatment is performed using a rotating bundled brush. In FIG. 4, 31 represents an aluminum plate, 32 and 34 represent roller-shaped brushes (bundled brushes in the present example), 33 represents a polishing slurry liquid, and 35, 36, 37, and 38 represent support rollers.

The mechanical roughening treatment is performed under conditions in which the median diameter (µm) of a polishing material was 30 µm, the number of the brushes was four, and the rotation speed (rpm) of the brushes was set to 250 rpm. The bundle brush was made of 6·10 nylon and consisted of bristles having a diameter of 0.3 mm and a length of 50 mm. The brush was configured in such a manner that holes were drilled into a stainless steel cylinder having a diameter of φ 300 mm and bristles were planted densely in the holes. The distance between two support rollers (φ 200 mm) under the bundled brush was 300 mm. The bundle brush was pressed down until the load of the drive motor for rotating the brush was 10 kW or more than the load applied before the bundle brush was pressed down against the aluminum plate. The rotation direction of the brush was the same as the movement direction of the aluminum plate.

### (J-b) Alkali etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. The amount of aluminum dissolved in the surface to be subsequently subjected to an electrochemical roughening treatment was 10 g/m².

### (J-c) Desmutting treatment using aqueous acidic solution

As an acidic aqueous solution, the waste liquid of nitric acid used in the following step, an electrochemical roughening treatment, at a liquid temperature of 35°C was sprayed on the aluminum plate for 3 seconds. In this way, a desmutting treatment was performed.

### (J-d) Electrochemical roughening treatment using nitric acid aqueous solution

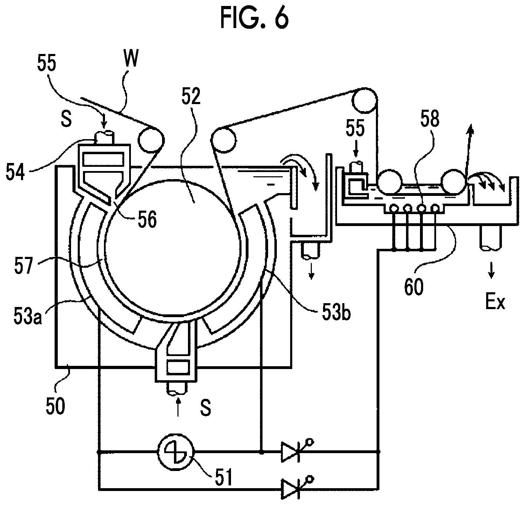

An electrochemical roughening treatment was continuously performed using an AC voltage of 60 Hz. An electrolytic solution at a liquid temperature of 35°C was used which was prepared by adding aluminum nitrate to 10.4 g/L aqueous nitric acid solution such that the aluminum ion concentration was adjusted to 4.5 g/L. The AC power source waveform is a waveform illustrated in FIG. 5. Further, using a trapezoidal rectangular waveform AC having a time tp, until the current value reached a peak from zero, of 0.8 msec and the duty ratio of 1:1 as the AC power source waveform, the electrochemical roughening treatment was performed using a carbon electrode as a counter electrode. Ferrite was used as an auxiliary anode. The electrolytic cell shown in FIG. 6 was used. The current density was 30 A/dm² in terms of the peak value of current, and 5% of the current coming from the power source was allowed to flow into the auxiliary anode. The quantity of electricity (C/dm²) was 185 C/dm², which is the total quantity of electricity in a case where the aluminum plate was the anode.

### (J-e) Alkaline etching treatment

The aluminum plate was subjected to an etching treatment by spraying a caustic soda aqueous solution in which the concentration of caustic soda was 27% by mass and the concentration of aluminum ions was 2.5% by mass using a spray at a temperature of 50°C. The amount of aluminum dissolved was 3.5 g/m².

### (J-f) Desmutting treatment using aqueous acidic solution

As an aqueous acidic solution, an aqueous solution at a liquid temperature of 30°C having a sulfuric acid concentration of 170 g/L and an aluminum ion concentration of 5 g/L was sprayed on an aluminum plate for 3 seconds, thereby performing a desmutting treatment.

### (J-g) Electrochemical roughening treatment using hydrochloric acid aqueous solution

An electrochemical roughening treatment was continuously performed using an AC voltage of 60 Hz. An electrolytic solution was used which was prepared by adding aluminum chloride to 6.2 g/L aqueous hydrochloric acid solution at a liquid temperature of 35°C such that the aluminum ion concentration was adjusted to 4.5 g/L. The AC power source waveform is a waveform illustrated in FIG. 5. Further, using a trapezoidal rectangular waveform AC having a time tp, until the current value reached a peak from zero, of 0.8 msec and the duty ratio of 1:1 as the AC power source waveform, the electrochemical roughening treatment was performed using a carbon electrode as a counter electrode. Ferrite was used as an auxiliary anode. The electrolytic cell shown in FIG. 6 was used. The current density was 25 A/dm² in terms of the peak value of current, and the quantity of electricity (C/dm²) during the hydrochloric acid electrolysis was 63 C/dm² which is the total quantity of electricity used during the anodization of the aluminum plate.

### (J-h) Alkali etching treatment

An aluminum plate was subjected to an etching treatment by spraying a caustic soda aqueous solution having a caustic soda concentration of 5% by mass and an aluminum ion concentration of 0.5% by mass, to the aluminum plate using a spray at a temperature of 60°C. The amount of aluminum dissolved was 0.2 g/m².

### (J-i) Desmutting treatment using aqueous acidic solution

As an aqueous acidic solution, an aqueous solution at a liquid temperature of 35°C (sulfuric acid concentration 170 g/L and aluminum ion concentration 5 g/L) which was a waste liquid generated in the anodization treatment step was sprayed on an aluminum plate for 4 seconds, thereby performing a desmutting treatment.

### (J-j) First-stage anodization treatment

By using the anodization device for direct current electrolysis having the structure shown in FIG. 3, a first-stage anodization treatment was performed. The aluminum plate was subjected to an anodizing treatment at a solution temperature of 50°C and a current density of 30A/dm² using a 170 g/L of sulfuric acid aqueous solution as an electrolyte, thereby forming an anodized film having a coating amount of 0.3 g/m².

### (J-k) Pore widening treatment

The aluminum plate after being subjected to the anodization treatment was subjected to a pore widening treatment by being immersed in a caustic soda aqueous solution having a caustic soda concentration of 5% by mass and an aluminum ion concentration of 0.5% by mass at a temperature of 40°C for 3 seconds.

### (J-l) Second stage anodization treatment

By using the anodization device for direct current electrolysis having the structure shown in FIG. 3, a second-stage anodization treatment was performed. The anodization treatment was performed using a 170 g/L sulfuric acid aqueous solution as an electrolytic solution under conditions of a liquid temperature of 50°C and a current density of 13 A/dm² to form an anodized film having a coating amount of 2.1 g/m².

### (J-m) Hydrophilization treatment

In order to ensure hydrophilicity of a non-image area, the aluminum plate area was subjected to a silicate treatment by being immersed in a 2.5% by mass of No. 3 sodium silicate aqueous solution at 50°C for 7 seconds. The adhesion amount of Si was 8.5 mg/m². The average diameter of the micropores was 30 nm.

The value of the brightness L* of the surface of the anodic oxide film of the support 4 was 72.3 in the L*a*b* color system.

### <Formation of Undercoat Layer>

### -Formation of Undercoat Layer 1-

The support was coated with an undercoat layer coating liquid (1) having the following composition such that the dry coating amount was 0.03 g/m². In this way, an undercoat layer 1 was formed.

### <<coating liquid (1) for undercoat layer>>

· Polyacrylic acid aqueous solution (40% by mass, JURYMER AC-10S, manufactured by TOAGOSEI CO., LTD.): 3.0 parts
· Water: 27.0 parts

### -Formation of undercoat layer 2-

The support was coated with an undercoat layer coating solution (2) having the following composition such that the drying coating amount was 0.1 g/m², thereby forming an undercoat layer 2.

### <Coating liquid for undercoat layer (2)>

· Compound for undercoat layer (3): 0.010 parts
· Chelest 400 (chelating agent; manufactured by Chelest Co., Ltd.): 0.0280 parts
· Chelest 3EAF (chelating agent; manufactured by Chelest Co., Ltd.): 0.0499 parts
· Surfactant (EMALEX (registered trademark) 710, manufactured by NIHON EMULSION Co., Ltd.): 0.00159 parts
· Preservative (BIOHOPE L, manufactured by K·I Chemical Industry Co., LTD.): 0.00149 parts
· Water: 2.8219 parts

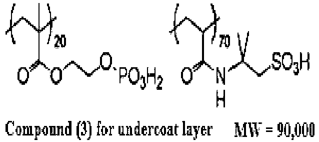

### -Formation of undercoat layer 3-

The support was coated with an undercoat layer coating liquid (3) having the following composition such that the dry coating amount was 26 mg/m². In this way, an undercoat layer 3 was formed.

### <<Coating liquid (3) for undercoat layer>>

· Compound (2) for undercoat layer (the following structure): 0.013 parts
· Hydroxyethyl iminodiacetic acid: 0.005 parts
· Tetrasodium ethylenediaminetetraacetate: 0.005 parts
· Polyoxyethylene lauryl ether: 0.0003 parts
· Water: 3.15 parts

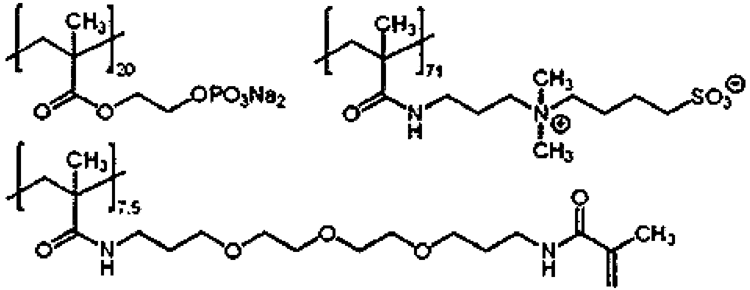

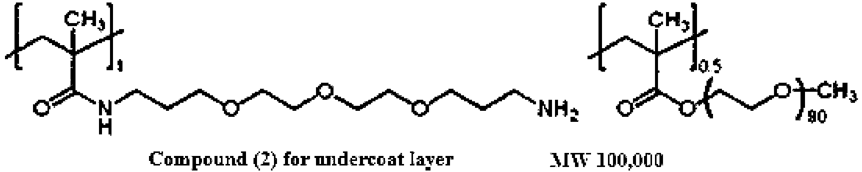

The numerical values on the lower right side of the parentheses of each structural unit in the above-described compound (2) for an undercoat layer indicate the mass ratios, and the numerical values on the lower right side of the parentheses of each ethyleneoxy unit indicate the repetition numbers.

### <Formation of image recording layer>

### -Formation of image recording layers 1 to 14-

The image recording layers 1 to 14 were each bar-coated with each of image recording layer coating liquids (image recording layer coating liquids (1) to (13)) having the following composition, and dried in an oven at 110°C for 40 seconds to produce an image recording layer having a dry weight of 0.8 g/m².

### <<Image recording layer coating liquids (1) to (14)>>

· 1-Propanol: 5.000 parts
· 2-Butanone: 2.500 parts
· 1-Methoxy-2-propanol: 4.200 parts
· γ-Butyrolactone: 0.1500 parts
· Water: 0.6600 parts
· Polymer particles (20% by mass) described in Table 1: amount described in Table 1
· KLUCEL E^{*1}: 0.0070 parts
· BYK 336^{*2}: 0.0720 parts
· Iodonium salt (I-1): 0.9500 parts
· Infrared absorber (IR-1): 0.4500 parts
· Polymerizable compound (M-1): 0.4250 parts
· Polymerizable compound (M-2): 0.2125 parts
· Color forming agent (S-1): 0.0200 parts
*1: KLUCEL E means hydroxypropyl cellulose available from Hercules Incorporated.
*2: Xylene/methoxypropyl acetate solution (manufactured by BYK-Chemie GmbH) containing a modified polydimethylsiloxane copolymer at a concentration of 25% by mass

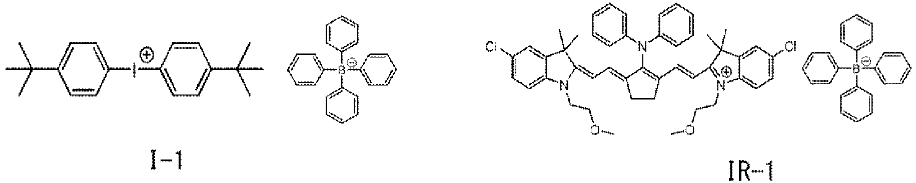

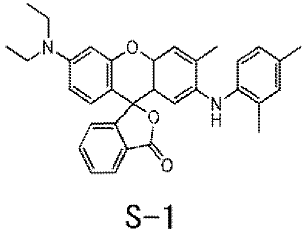

M-1 is a urethane acrylate (40% by mass 2-butanone solution) obtained by reacting DESMODUR (registered trademark) N100 (manufactured by Bayer Corporation, Milford, CT) with hydroxyethyl acetate and pentaerythritol triacrylate at a molar ratio of about 1:1.5:1.5

M-2 is bisphenol A ethoxylate (10 mol ethylene oxide (EO) adduct) diacrylate (40% by mass 2-butanone solution)

### -Formation of image recording layer 15-

The image recording layer 15 was bar-coated with an image recording layer coating liquid (15) having the following formulation and dried in an oven at 120°C for 40 seconds to produce an image recording layer 15 having a dry weight of 1.0 g/m².

### <Coating liquid for image recording layer (15)>

· Infrared absorber (the following IR-2): 0.0200 parts
· Infrared absorber (the following IR-3): 0.0050 parts
· Color forming agent (the following S-2): 0.0300 parts
· Color forming agent (the following S-3): 0.0120 parts
· Onium-based polymerization initiator (the following I-2): 0.0980 parts
· Borate compound (sodium tetraphenylborate (TPB)): 0.0270 parts
· Polymerizable compound (the following M-3): 0.4363 parts
· Fluorine-based surfactant (1) (the following structure): 0.004 parts
· Anionic surfactant (A-1, 30%): 0.1620 parts
· 2-Butanone: 6.0000 parts
· 1-Methoxy-2-propanol: 3.7000 parts
· Methanol: 2.3000 parts
· Polymer particles (R-1, 20% by mass): 2.2500 parts (in Table 1, the amount converted into the amount in the image recording layer coating liquids (1) to (14) is described)

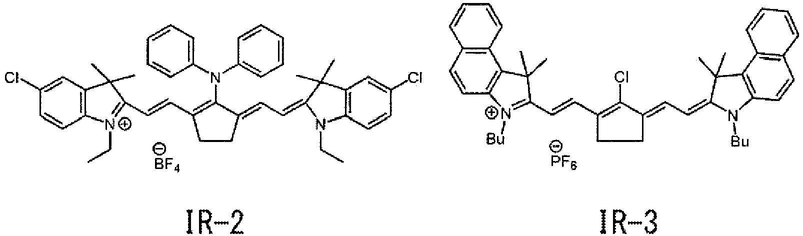

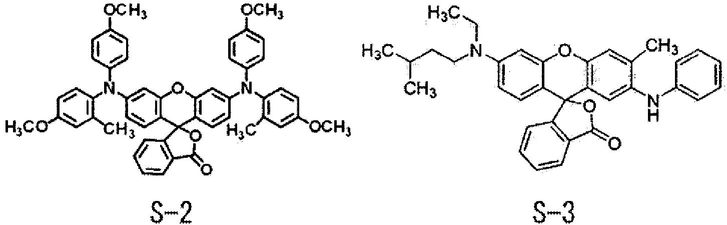

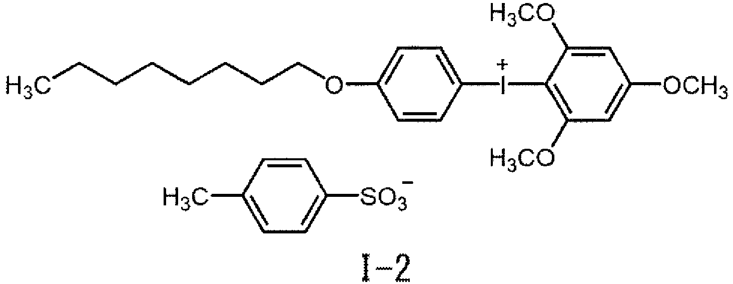

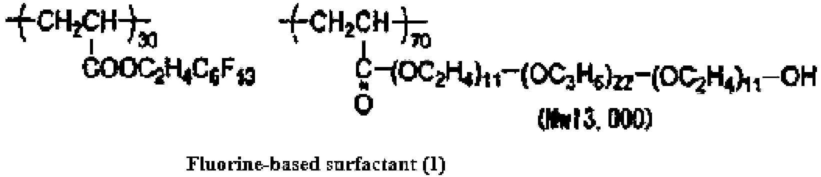

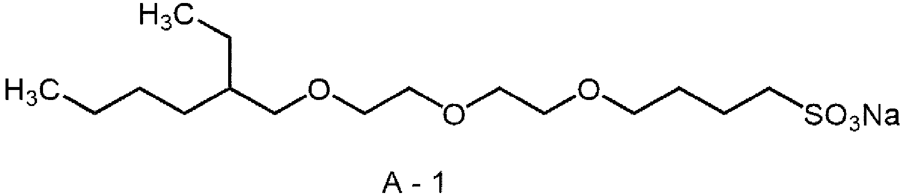

### <<Synthesis method of polymerizable compound M-3>>

A mixed solution of TAKENATE D-160N (polyisocyanate trimethylolpropane adduct, manufactured by Mitsui Chemicals, Inc., 4.7 parts), ARONIX M-403 (manufactured by TOAGOSEI CO., LTD., amount yielding the ratio of NCO value of TAKENATE D-160N:hydroxyl number of ARONIX M-403 = 1:1), t-butylbenzoquinone (0.02 parts), and methyl ethyl ketone (11.5 parts) was heated at 65°C. NEOSTANN U-600 (bismuth-based polycondensation catalyst, manufactured by NITTO KASEI CO., LTD., 0.11 parts) was added to the reaction solution, and the reaction solution was heated at 65°C for 4 hours. The reaction solution was cooled to room temperature (25°C), and methyl ethyl ketone was added thereto, thereby synthesizing a urethane acrylate (polymerizable M-4) solution having a solid content of 70% by mass. By using recycling GPC (instrument: LC908-C60, column: JAIGEL-1H-40 and 2H-40 (manufactured by Japan Analytical Industry Co., Ltd.)) and tetrahydrofuran (THF) as an eluent, molecular weight fractionation of the urethane acrylate solution was performed. The weight-average molecular weight thereof was 20,000.

### <Formation of overcoat layer>

### -Formation of overcoat layer 1-

The image recording layer was bar-coated with an overcoat layer coating liquid (1) having the following composition, and dried in an oven at 120°C for 60 seconds to form an overcoat layer 1 having a dry coating amount of 0.1 g/m².

### <<Coating liquid (1) for overcoat>>

· Inorganic lamellar compound dispersion liquid (1) (described below): 0.625 parts
· Hydrophilic polymer (1) (the following structure, Mw: 30,000): 0.03 parts
· METOLOSE SM04: 0.0600 parts
· RAPISOL A-80 (80% aqueous solution): 0.0063 parts
· Water: 2.0 parts

### <<Preparation of inorganic lamellar compound dispersion (1)>>

Synthetic mica SOMASIF ME-100 manufactured by Co-op Chemical Co., Ltd., 6.4 parts) was added to 193.6 parts of deionized water and was dispersed using a homogenizer until the volume average particle diameter (the laser scattering method) reached 3 µm. The aspect ratio of the obtained dispersed particles was 100 or greater.

### -Formation of overcoat layer 2-

The image recording layer was coated with an overcoat layer coating liquid (2) having the following composition such that the dry film thickness was 1.0 µm, and dried in an oven at 100°C for 60 seconds to form an overcoat layer 2.

### <<Overcoat layer coating solution(2)>>

· POVAL PVA105 (polyvinyl alcohol, saponification degree = 98 mol% to 99 mol%, manufactured by Kuraray Co., Ltd.): 1.0 part by mass
· PEG4000 (manufactured by Tokyo Chemical Industry Co., Ltd.): 0.39 parts by mass
· Surfactant (RAPISOL A-80, manufactured by NOF Corporation): 0.01 parts by mass
· Water: amount set such that total amount reached 10 parts by mass

As shown in Table 1, each support, undercoat layer, image recording layer, and as necessary, overcoat layer were formed to obtain lithographic printing plate precursors of Examples 1 to 20 and Comparative Examples 1 and 2.

### (Printing durability evaluation)

By using Magnus 800 Quantum manufactured by Kodak Japan Ltd. that was equipped with an infrared semiconductor laser, the obtained lithographic printing plate precursor was exposed (equivalent to irradiation energy of 110 mJ/cm²) under the conditions of output of 27 W, an outer drum rotation speed of 450 rpm, and a resolution of 2,400 dots per inch (dpi, 1 inch is equal to 2.54 cm). The exposure image included a solid image and an amplitude modulation screen (AM screen) as a 10% halftone dot chart.

The obtained exposed precursor was mounted on a Kikuban-sized cylinder of a printer SX-74 manufactured by Heidelberger Druckmaschinen AG without being developed. The printing press was connected to a 100 L dampening water circulation tank incorporating a nonwoven filter and a temperature controlling device. A circulation device was filled with 80 L of dampening water containing 3.5% dampening water S-Z1 (manufactured by FUJIFILM Corporation), UV CORE TYPE-A J ink GE M (manufactured by T&K TOKA CO., LTD.) was used as printing ink, dampening water and ink were supplied by a standard automatic printing start method, and then 1,000 sheets were printed on SHIRAOI paper (ream weight: 48.5 kg, manufactured by NIPPON PAPER INDUSTRIES Co., Ltd.) at a printing speed of 10,000 sheets per hour.

Then, printing was performed further. As the number of printing sheets increased, the image area gradually wore out, and thus the ink density on the printed matter decreased. The print durability was evaluated by determining the number of printed sheets, which is designated as the number of finished printed sheets, in a case where the halftone dot area ratio of a 10% AM screen dot on a printed material, which is measured using an eXact spectrophotometer (manufactured by X-Rite), was decreased by 3% compared to the measurement value at the 1,000th print. UV printing durability was evaluated according to the following standard, based on relative printing durability to 100 which represents the printing durability of a lithographic printing plate precursor capable of printing 50,000 sheets. The higher the numerical value, the better the printing durability. 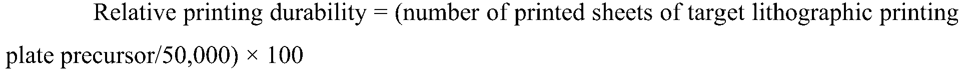 Relative printing durability = (number of printed sheets of target lithographic printing plate precursor/50,000) × 100

### -Evaluation criteria-

5: The value of relative printing durability is more than 110.
4: The value of relative printing durability is more than 100 and 110 or less.
3: The value of relative printing durability is more than 90 and 100 or less.
2: The value of relative printing durability is more than 75 and 90 or less.
1: The value of relative printing durability is 75 or less.

### (Evaluation of on-press development scum resistance (developing residue suppressing property))

Each of the obtained planographic printing plate precursors was exposed by Luxel PLATESETTER T-6000III (manufactured by Fujifilm Corporation) equipped with an infrared semiconductor laser under conditions of an external drum rotation speed of 1000 rpm, a laser output of 70%, and a resolution of 2400 dpi. The exposed image included a solid image and a 50% mesh dot chart of a 20 µm dot FM screen.

The obtained exposed precursor was attached to the plate cylinder of a printing press LITHRONE26 (manufactured by KOMORI Corporation) without performing a development treatment. Using dampening water of Ecolity-2 (manufactured by FUJIFILM Corporation)/tap water = 2/98 (volume ratio) and Space Color Fusion G yellow ink (manufactured by DIC Graphics Corp.), the dampening water and the ink were supplied by a standard automatic printing start method of LITHRONE26 to perform on-press development, and then printing was performed on 500 sheets of TOKUBISHI Art (manufactured by MITSUBISHI PAPER MILLS LIMITED., basis weight: 76.5 kg) paper at a printing speed of 10,000 sheets/hour.

After replacing the plate with a new plate, the above-described on-press developability evaluation was repeated three times, the developing residue adhering to the dampening roller in the printer was transferred to a cellophane tape, and the cellophane tape was attached to OK top coat paper (manufactured by OJI PAPER CO., LTD., model number: OK top coat +), and the cyan color density D(C) was measured with a color density meter X-Rite (manufactured by X-Rite).

### -Evaluation criteria-

Evaluation 1: D(C) was lower than 0.1.
Evaluation 2: D(C) was 0.1 or higher and lower than 0.3.
Evaluation 3: D(C) was 0.3 or higher and lower than 0.5.
Evaluation 4: D(C) was 0.5 or higher and lower than 1.0.
Evaluation 5: D(C) was 1.0 or higher.

**[Table 1]**

| | Support | Undercoat layer | Image recording layer | | | | | Standard deviation of area ratio (%) of non-stained portion | Overcoat layer | Evaluation result | |
|---|---|---|---|---|---|---|---|---|---|---|---|
| | | | Type | Polymer particle | | | | | | | |
| | | | | Type | Median diameter (nm) | Addition amount (part) | Content of polymer particle in image recording layer (% by mass) | | | | |
| Example 1 | Support 1 | Undercoat layer 1 | Image recording layer 1 | R-1 | 75 | 3.3000 | 60 | 4.0 | - | 4 | 4 |
| Example 2 | Support 1 | Undercoat layer 1 | Image recording layer 2 | R-1 | 75 | 1.8000 | 45 | 5.8 | - | 3 | 3 |
| Example 3 | Support 1 | Undercoat layer 1 | Image recording layer 3 | R-1 | 75 | 2.6889 | 55 | 4.6 | - | 4 | 4 |
| Example 4 | Support 1 | Undercoat layer 1 | Image recording layer 4 | R-1 | 75 | 6.6000 | 75 | 3.3 | - | 3 | 4 |
| Example 5 | Support 1 | Undercoat layer 1 | Image recording layer 5 | R-2 | 75 | 3.3000 | 60 | 4.2 | - | 4 | 4 |
| Example 6 | Support 1 | Undercoat layer 1 | Image recording layer 6 | R-3 | 75 | 3.3000 | 60 | 3.8 | - | 4 | 4 |
| Example 7 | Support 1 | Undercoat layer 1 | Image recording layer 7 | R-4 | 75 | 3.3000 | 60 | 4.7 | - | 3 | 3 |
| Example 8 | Support 1 | Undercoat layer 1 | Image recording layer 8 | R-5 | 75 | 3.3000 | 60 | 4.3 | - | 4 | 3 |
| Example 9 | Support 1 | Undercoat layer 1 | Image recording layer 9 | R-6 | 50 | 3.3000 | 60 | 5.7 | - | 3 | 4 |
| Example 10 | Support 1 | Undercoat layer 1 | Image recording layer 10 | R-7 | 90 | 3.3000 | 60 | 3.8 | - | 4 | 4 |
| Example 11 | Support 1 | Undercoat layer 1 | Image recording layer 11 | R-8 | 75 | 3.3000 | 60 | 4.1 | - | 4 | 3 |
| Example 12 | Support 1 | Undercoat layer 1 | Image recording layer 12 | R-9 | 120 | 3.3000 | 60 | 3.7 | - | 3 | 3 |
| Example 13 | Support 1 | Undercoat layer 1 | Image recording layer 15 | R-1 | 75 | 3.3611 | 55 | 4.0 | - | 4 | 3 |
| Example 14 | Support 2 | Undercoat layer 1 | Image recording layer 1 | R-1 | 75 | 3.3000 | 60 | 4.0 | - | 4 | 4 |
| Example 15 | Support 3 | Undercoat layer 1 | Image recording layer 1 | R-1 | 75 | 3.3000 | 60 | 4.0 | - | 4 | 3 |
| Example 16 | Support 4 | Undercoat layer 1 | Image recording layer 1 | R-1 | 75 | 3.3000 | 60 | 4.0 | - | 4 | 4 |
| Example 17 | Support 1 | Undercoat layer 2 | Image recording layer 1 | R-1 | 75 | 3.3000 | 60 | 4.0 | - | 4 | 4 |
| Example 18 | Support 1 | Undercoat layer 3 | Image recording layer 1 | R-1 | 75 | 3.3000 | 60 | 4.0 | - | 5 | 4 |
| Example 19 | Support 1 | Undercoat layer 1 | Image recording layer 1 | R-1 | 75 | 3.3000 | 60 | 4.0 | Overcoat layer 1 | 5 | 3 |
| Example 20 | Support 1 | Undercoat layer 1 | Image recording layer 1 | R-1 | 75 | 3.3000 | 60 | 4.0 | Overcoat layer 2 | 5 | 3 |
| Comparative Example 1 | Support 1 | Undercoat layer 1 | Image recording layer 13 | R-1 | 75 | 1.4667 | 40 | 7.0 | - | 2 | 2 |
| Comparative Example 2 | Support 1 | Undercoat layer 1 | Image recording layer 14 | R-10 | 175 | 1.8000 | 45 | 3.5 | - | 2 | 2 |

The details of each of the polymer particles shown in Table 1 are shown in Table 2.

**[Table 2]**

| Polymer particle | Type of each structural unit | Mass ratio of each structural unit | Median diameter (nm) | PEGMA (Mn) | Amount of azobisisobutyronitrile |
|---|---|---|---|---|---|
| R-1 | St/AN/PEGMA | 20/70/10 | 75 | 232 | 0.3% |
| R-2 | St/AN/PEGMA | 20/70/10 | 75 | 2,000 | 4% |
| R-3 | St/AN/PEGMA | 10/70/20 | 75 | 2,000 | 1% |
| R-4 | St/PEGMA | 85/15 | 75 | 232 | 0.3% |
| R-5 | AN/PEGMA | 85/15 | 75 | 232 | 0.3% |
| R-6 | St/AN/PEGMA | 20/70/10 | 50 | 232 | 1% |
| R-7 | St/AN/PEGMA | 20/70/10 | 90 | 500 | 0.3% |
| R-8 | St/AN/PEGMA | 25/65/10 | 75 | 232 | 0.3% |
| R-9 | St/AN/PEGMA | 20/70/10 | 120 | 1,000 | 0.3% |
| R-10 | St/AN/PEGMA | 20/70/10 | 175 | 2,000 | 0.3% |

### <Synthesis Example 1 (synthesis of R-1)>

218 g of 1-propanol and 5 g of polyethylene glycol monomethyl ether acrylate (Mn = 232, number of repeating units of polyethylene oxide structure: 3) were added to a three-neck flask under a nitrogen flow, and the mixture was heated to 75°C. 10 g of styrene and 35 g of acrylonitrile were mixed, and a solution obtained by dissolving 0.35 g of azobisisobutyronitrile (0.3 mol% with respect to the monomer) was added dropwise thereto over 2 hours. Thereafter, the mixture was allowed to react at 75°C for 2 hours. The obtained particles (R-1) were measured by a dynamic light scattering method, and the median diameter thereof was 75 nm.

### <Synthesis Examples 2 to 10: synthesis of R-2 to R-10>

Each of particles (R-2 to R-10) was synthesized in the same manner as in the synthesis of R-1, except that the mass ratio of each structural unit, the molecular weight of polyethylene glycol monomethyl ether acrylate, and the addition amount of azobisisobutyronitrile were changed to the amounts shown in Table 2.

The abbreviations of the structural units shown in Table 2 are structural units formed of the following units.
St: Styrene
AN: Acrylonitrile
PEGMa: polyethylene glycol monomethyl ether acrylate

From the results shown in Table 1, it was found that the lithographic printing plate precursors according to Examples had excellent printing durability and excellent developing residue suppressing property.

The disclosure of JP2020-199129 filed on November 31, 2023 is incorporated in the present specification by reference in its entirety.

All documents, patent applications, and technical standards described in the present specification are herein incorporated by reference to the same extent that each individual document, patent application, or technical standard was specifically and individually indicated to be incorporated by reference.

### Explanation of References

12a, 12b: aluminum support
14: undercoat layer
16: image recording layer
18: aluminum plate
20a, 20b: anodized film
22a, 22b: micropore
24: large diameter portion
26: small-diameter pore
D: depth of large diameter portion
30: lithographic printing plate precursor
31: aluminum plate
32, 34: roller-shaped brush
33: polishing slurry liquid
35, 36, 37, 38: support roller
50: main electrolytic cell
51: alternating current power source
52: radial drum roller
53a, 53b: main pole
54: electrolytic solution supply port
55: electrolytic solution
56: auxiliary anode
57: electrolytic liquid channel
58: auxiliary anode
60: auxiliary anode tank
610: anodization treatment device
612: power supply tank
614: electrolytic treatment tank
616: aluminum plate
618, 26: electrolytic solution
620: power supply electrode
622, 628: roller
624: nip roller
630: electrolysis electrode
632: tank wall
634: DC power source
W: aluminum plate
S: supply liquid direction
Ex: electrolytic solution discharge direction
ta: anodic reaction time
tc: cathodic reaction time
tp: time until the current value reached a peak from zero
Ia: peak current on anode cycle side
Ic: peak current on cathode cycle side
AA: current of anodic reaction of aluminum plate
CA: current of cathodic reaction of aluminum plate

## Claims

1. An on-press development type lithographic printing plate precursor comprising:
a support; and
an image recording layer on the support,
wherein the image recording layer contains a polymerizable compound and polymer particles,
a median diameter of the polymer particles is in a range of 50 nm to 120 nm,
a content of the polymer particles is 42% by mass or more and 90% by mass or less with respect to a total mass of the image recording layer, and
a standard deviation of an area ratio of a non-stained portion in a cross-sectional image is less than 6, the cross-sectional image being obtained by performing an osmium staining treatment on a cross section of the lithographic printing plate precursor in a thickness direction, performing observation the cross section with a scanning electron microscope, and binarizing the cross-sectional image into a stained portion and the non-stained portion.

2. The on-press development type lithographic printing plate precursor according to claim 1,
wherein the polymer particles are polymer particles having a structural unit formed from an acrylonitrile compound and a structural unit having a polyalkylene oxide structure.

3. The on-press development type lithographic printing plate precursor according to claim 2,
wherein the polymer particles are polymer particles having a structural unit formed of an aromatic vinyl compound, a structural unit formed of an acrylonitrile compound, and a structural unit having a polyalkylene oxide structure.

4. The on-press development type lithographic printing plate precursor according to claim 2,
wherein the polyalkylene oxide structure is a polyethylene oxide structure.

5. The on-press development type lithographic printing plate precursor according to claim 2,
wherein the number of repeating units of the polyalkylene oxide structure is in a range of 3 to 10.

6. The on-press development type lithographic printing plate precursor according to claim 2,
wherein a content of the structural unit having a polyalkylene oxide structure in the polymer particles is 10% by mass or more with respect to a total mass of a polymer.

7. The on-press development type lithographic printing plate precursor according to claim 1 or 2,
wherein the content of the polymer particles is 45% by mass or more with respect to the total mass of the image recording layer.

8. The on-press development type lithographic printing plate precursor according to claim 7,
wherein the content of the polymer particles is 55% by mass or more with respect to the total mass of the image recording layer.

9. The on-press development type lithographic printing plate precursor according to claim 1 or 2,
wherein the median diameter of the polymer particles is in a range of 50 nm to 100 nm.

10. The on-press development type lithographic printing plate precursor according to claim 9,
wherein the median diameter of the polymer particles is in a range of 50 nm to 90 nm.

11. The on-press development type lithographic printing plate precursor according to claim 1 or 2,
wherein the polymerizable compound contains an oligomer.

12. The on-press development type lithographic printing plate precursor according to claim 1 or 2, further comprising:
an interlayer between the support and the image recording layer,
wherein the interlayer contains a copolymer having a support absorptive group and a hydrophilic group.

13. The on-press development type lithographic printing plate precursor according to claim 1 or 2, further comprising:
an overcoat layer on the image recording layer, the overcoat layer containing an inorganic lamellar compound.

14. The on-press development type lithographic printing plate precursor according to claim 1 or 2, further comprising:
an overcoat layer on the image recording layer, the overcoat layer containing a water-soluble polymer,
wherein a thickness of the overcoat layer is greater than a thickness of the image recording layer.

15. The on-press development type lithographic printing plate precursor according to claim 1 or 2, further comprising:
an oxide film on a surface of the support,
wherein the oxide film has micropores extending in a depth direction from a surface of the oxide film on a side of the image recording layer in the oxide film, and a large-diameter pore portion in which an average pore diameter of the micropores at the surface of the oxide film is in a range of 15 nm or greater and 100 nm or less and a small-diameter pore portion having an average pore diameter of 15 nm or less, small-diameter pore portion communicating with a bottom portion of the large-diameter pore portion and further extending in the depth direction from a communicating position.

16. The on-press development type lithographic printing plate precursor according to claim 1 or 2, further comprising:
an oxide film on a surface of the support,
wherein the oxide film has micropores extending in a depth direction from a surface of the oxide film on a side of the image recording layer in the oxide film, and a maximum diameter inside the micropores is 1.2 to 10 times an average pore diameter of the surface of the oxide film with respect to an average pore diameter of the micropores at the surface of the oxide film.

17. An on-press development type lithographic printing plate precursor comprising: a support; and
an image recording layer on the support,
wherein the image recording layer contains a polymerizable compound and polymer particles,
a median diameter of the polymer particles is 50 nm to 120 nm,
a content of the polymer particles is 42% by mass or more and 90% by mass or less with respect to a total mass of the image recording layer, and
the polymer particles are polymer particles having a structural unit formed of an acrylonitrile compound in an amount of 65% by mass or more and a structural unit having a polyalkylene oxide structure in an amount of 10% by mass or more with respect to a total mass of the polymer particles.

18. A method of preparing a lithographic printing plate, comprising:
a step of exposing the on-press development type lithographic printing plate precursor according to claim 1 or 17 in an imagewise manner; and
a step of supplying at least one selected from the group consisting of a printing ink and dampening water on a printing press to remove an image recording layer in a non-image area.

19. A lithographic printing method comprising:
a step of exposing the on-press development type lithographic printing plate precursor according to claim 1 or 17 in an imagewise manner;
a step of supplying at least one selected from the group consisting of a printing ink and dampening water on a printing press to remove an image recording layer in a non-image area and to prepare a lithographic printing plate; and
a step of performing printing using the obtained lithographic printing plate.
